# EUROPEAN PATENT APPLICATION

(11) **EP 4 325 291 A1**
(43) Date of publication of application: **21.02.2024**
(21) Application number: 23190054.9
(22) Date of filing: 07.08.2023
(51) Int. Cl.: G03F 7/004, G03F 7/09

(54) **WAFER EDGE PROTECTION FILM FORMING METHOD, PATTERNING PROCESS, AND COMPOSITION FOR FORMING WAFER EDGE PROTECTION FILM**

(30) Priority: 10.08.2022 JP 2022127751
(71) Applicant: SHIN-ETSU CHEMICAL CO., LTD., Tokyo 1000005 (JP)
(72) Inventor: Kobayashi, Naoki, Niigata (JP); Yano, Toshiharu, Niigata (JP)
(74) Representative: Sonnenhauser, Thomas Martin

(57) **Abstract**

An object of the present invention is to provide a wafer edge protection film having dry etching resistance superior to those of the previously-known wafer edge protection films, as well as excellent film forming property even at wafer edge portions, which are difficult to coat: a wafer edge protection film forming method for forming a protection film on a wafer edge of a substrate, including the steps of (i) coating a peripheral edge of the substrate with a composition for forming a protection film including an aromatic ring-containing resin (A) having an organic group represented by the following general formula (1), and a solvent; and (ii) curing the applied composition for forming a protection film by heat or optical irradiation to form the protection film on the peripheral edge of the substrate. 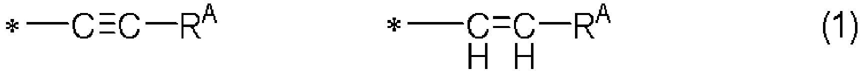 wherein R^{A} is a hydrogen atom or a monovalent organic group having 1 to 10 carbon atoms, and * represents a bonding site.

## Description

### TECHNICAL FIELD

The present invention relates to a method for forming a protection film on a peripheral edge of a substrate, and a patterning process using the protection film.

### BACKGROUND ART

In the manufacturing process of semiconductor devices, for example, a resist coating process of applying a resist chemical on a semiconductor substrate to form a resist upper layer film, an exposure process of exposing the resulting resist film to form a predetermined pattern, a development process of developing the exposed resist upper layer film, and the like, are sequentially performed to form a resist pattern on a substrate. Then, using the resist pattern as a mask, an etching process is performed to form a predetermined pattern on the substrate.

In such substrate processing, when the resist upper layer film pattern is used as a mask to etch the substrate to be processed, if there is any substrate peripheral edge (wafer edge) on which the substrate is exposed, a problem arises in which the substrate in the exposed portion is etched to generate particles, resulting in an influence on yield reduction of semiconductor manufacturing.

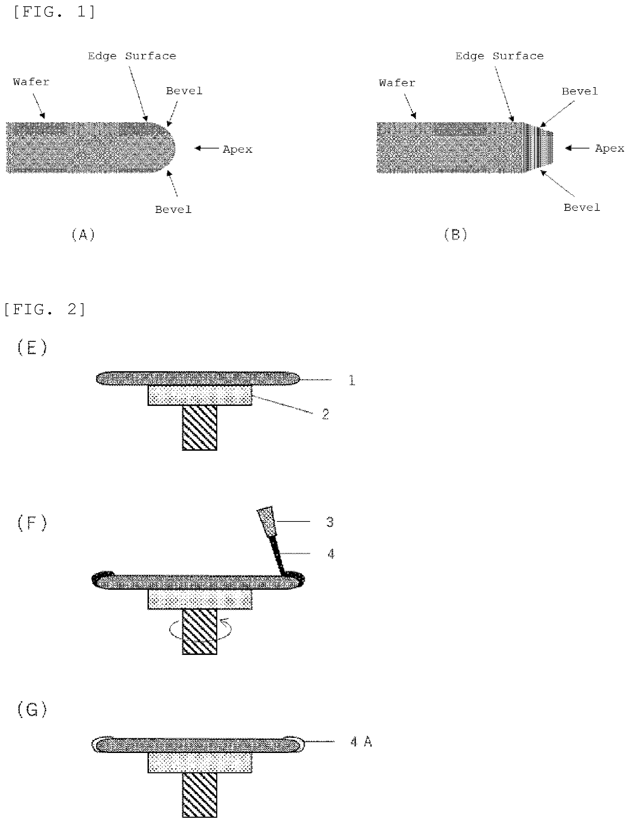

The wafer edge usually has a shape that gradually slopes down from the substrate surface and is cut off, as shown in FIG. 1. The beveled portion of the wafer edge is referred to as a "bevel", while the vertical portion is referred to as an "apex". The shape of the wafer edge shown in FIG. 1(A) is called a round type, and the shape of the wafer edge shown in FIG. 1(B) is called a bullet type.

In order to suppress particle generation from the wafer edge, a technique to form a resist film only on the wafer edge has been known. For example, as disclosed in Patent Document 1, a method of applying a photoresist solution to the wafer edge while rotating the wafer has been known.

Further, in recent years, it has been considered to form a coating film using a coating type material containing an inorganic metal as a resist or a resist underlayer film. Since metal adhesion to unintended parts of semiconductor substrate during the semiconductor apparatus production process strongly affects the electric properties of the semiconductor apparatus, strict controls have been in place to prevent such metal adhesion.

However, during the formation of a coating film containing a metal described above, there is a concern that the chemical liquid supplied to the surface of the substrate may run into the wafer edge or the peripheral portion on the backside, thus forming a coating film also on these unintended parts, i.e., the wafer edge and the peripheral portion on the backside, resulting in metal contamination in these areas. There is also concern that particles generated during etching of the metal-containing film will adhere to the wafer edge, resulting in metal contamination in these areas. Further, if the contaminated areas of the substrate come into contact with a substrate processing apparatus, such as an exposure apparatus or an etching apparatus, or a substrate transfer mechanism, the subsequent substrate to be transferred and processed after this substrate through these processing and transfer mechanisms may also be contaminated with a metal, that is, cross-contamination may occur. Therefore, as disclosed in Patent Documents 2 and 3, methods for forming protection films to protect wafer edge and peripheral portion on the backside from metal-containing materials have been reported.

As described above, the wafer edge protection film forming method is useful in the fine patterning process in semiconductor manufacturing process to suppress etching damage to the wafer edge and metal contamination to the wafer edge during processing of metal-containing materials.

On the other hand, the recent manufacturing of semiconductor devices perform more processes of forming patterns with ultra-high aspect ratios on substrates to be processed with the development of 3D device structures. Although negative photoresist liquids have been commonly used for previously-known wafer edge protection films, because of rapid increases in complication and lengthy processing time of etching processes in the manufacturing of advanced devices, the etching resistance of wafer edge protection films is expected to be improved.

### CITATION LIST

### PATENT LITERATURE

Patent Document 1: Japanese Laid-Open Patent Application Publication No. 2014-110386
Patent Document 2: Japanese Laid-Open Patent Application Publication No. 2014-045171
Patent Document 3: Japanese Laid-Open Patent Application Publication No. 2018-124354

### SUMMARY OF INVENTION

### TECHNICAL PROBLEM

The present invention has been made in view of the above circumstances, and an object thereof is to provide a wafer edge protection film having dry etching resistance superior to those of the previously-known wafer edge protection films, as well as excellent uniform coatability even at wafer edge portions, which are difficult to coat.

### SOLUTION TO PROBLEM

In order to achieve the above object, the present invention provides:
a method for forming a protection film on a peripheral edge of a substrate, comprising the steps of:
(i) coating a peripheral edge of the substrate with a composition for forming a protection film comprising an aromatic ring-containing resin (A) having an organic group represented by the following general formula (1), and a solvent; and
(ii) curing the applied composition for forming a protection film by heat or optical irradiation to form the protection film on the peripheral edge of the substrate, 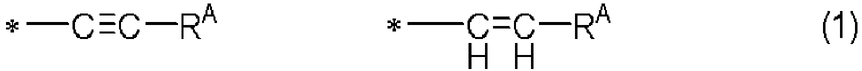
wherein R^{A} is a hydrogen atom or a monovalent organic group having 1 to 10 carbon atoms, and * represents a bonding site.

With this wafer edge protection film forming method, since the wafer edge protection film forming material containing a resin having an organic group represented by the above general formula (1) with excellent reactivity and thermal flowability and an aromatic ring with excellent dry etching resistance is used, it is possible to achieve excellent uniform coatability even at a wafer edge portion, which is difficult to coat. Further, the wafer edge can be protected even when a pattern with a high aspect ratio is formed on a substrate to be processed.

Further, the resin (A) preferably also has a hydroxyl group, and the ratio of the number of the hydroxyl groups to the number of the organic groups represented by the general formula (1) above preferably satisfies a relationship a+b=1 and 0.1≤b≤0.9 wherein "a" represents the proportion of the hydroxyl group and "b" represents the proportion of the organic group represented by the general formula (1) above.

Since the resin (A) described above has both a hydroxyl group and an organic group represented by the above general formula (1), a wafer edge protection film forming material having both excellent thermal flowability and substrate adhesiveness can be obtained. Therefore, it is possible to provide a wafer edge protection film forming method ensuring excellent uniform coatability even at wafer edge portions, which are difficult to coat. Further, when the contents of the organic group represented by the above general formula (1) and the hydroxyl group is within the above range, various physical properties required for use in the formation of wafer edge protection films, such as defect suppression properties, dry etching resistance, substrate adhesiveness, and the like, can be adjusted within an appropriate range.

Further, the resin (A) is preferably an aromatic ring-containing resin having a hydroxyl group and an organic group represented by the following general formula (1A), and the ratio of the number of the hydroxyl groups to the number of the organic groups represented by the general formula (1A) above preferably satisfies a relationship c+d=1 and 0.1≤d≤0.9 wherein "c" represents the proportion of the hydroxyl group and "d" represents the proportion of the organic group represented by the general formula (1A) above, 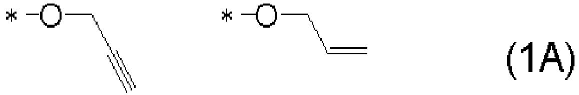 wherein * represents a bonding site.

Since the resin (A) described above has both a hydroxyl group and an organic group represented by the above general formula (1A), a wafer edge protection film forming material having both excellent thermal flowability and substrate adhesiveness can be obtained. Therefore, it is possible to provide a wafer edge protection film forming method ensuring excellent uniform coatability. Further, when the contents of the organic group represented by the above general formula (1A) and the hydroxyl group are within the above range, various physical properties required for use in the formation of wafer edge protection films, such as defect suppression properties, dry etching resistance, substrate adhesiveness, and the like, can be adjusted within an appropriate range.

Further, the resin (A) is preferably a compound having a ratio Mw/Mn (i.e., dispersity) in a range of 1.00≤Mw/Mn≤1.25, the Mw/Mn being a ratio of the weight average molecular weight Mw to the number average molecular weight Mn on polystyrene basis according to gel permeation chromatography.

With the wafer edge protection film forming material containing a compound having such a range of dispersity, the thermal flowability can be further improved, thereby achieving excellent uniform coatability.

Further, the resin (A) is preferably a polymer having a weight average molecular weight on polystyrene basis according to gel permeation chromatography of 1,000 to 12,000.

With this wafer edge protection film forming method using a wafer edge protection film forming material containing a polymer having such a range of weight average molecular weight, the solubility in an organic solvent is not impaired, and outgassing during baking can be suppressed.

Further, the resin (A) preferably comprises at least one of the constituent units represented by the following general formulae (A-1), (A-2), (A-3), (A-4), and (A-5), 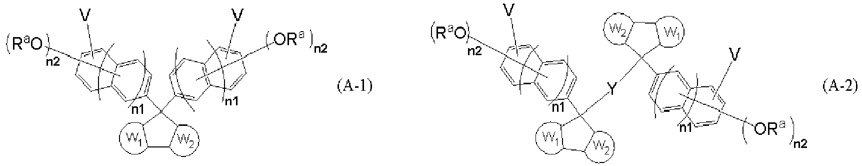 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom or an organic group represented by the following general formula (2), and satisfies a relationship e+f=1 and 0.1≤f≤0.9, wherein "e" represents the proportion of the hydrogen atom and "f" represents the proportion of the organic group represented by the general formula (2) above among the structures constituting R^{a}; Y is a group represented by the following general formula (3); n₁ is 0 or 1; n₂ is 1 or 2; and V independently represents a hydrogen atom or a connection portion, 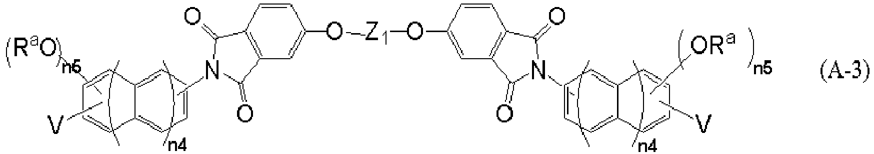 wherein Z₁ is a group represented by the following general formula (4), and R^{a} is a hydrogen atom or an organic group represented by the following general formula (2) and satisfies a relationship e+f=1 and 0.1≤f≤0.9, wherein "e" represents the proportion of the hydrogen atom and "f" represents the proportion of the organic group represented by the general formula (2) above among the structures constituting R^{a}; n₄ is 0 or 1; n₅ is 1 or 2; and V independently represents a hydrogen atom or a connection portion, 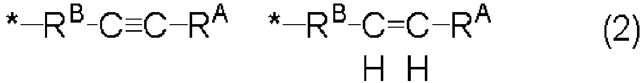 wherein * represents a site bonded with the oxygen atom; R^{B} is a divalent organic group having 1 to 10 carbon atoms; and R^{A} is a hydrogen atom or a monovalent organic group having 1 to 10 carbon atoms, 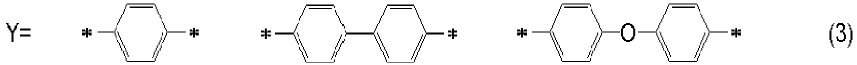 wherein * represents a bonding arm, 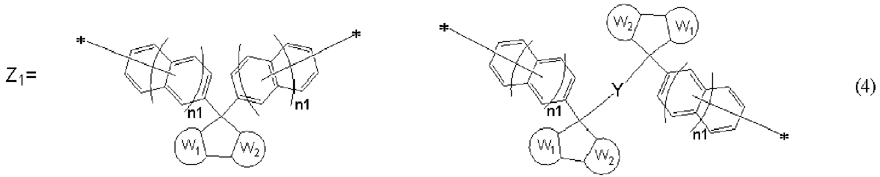 wherein W₁, W₂, Y, and n₁ are as defined above, 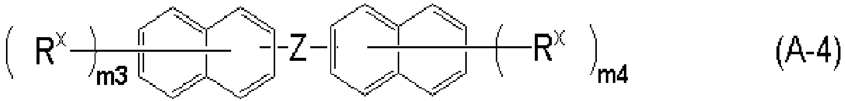 wherein m₃ and m₄ represent 1 or 2; and Z represents either a single bond or the structure represented by the following general formula (5); R^{X} is any one of the structures represented by the following general formula (6), 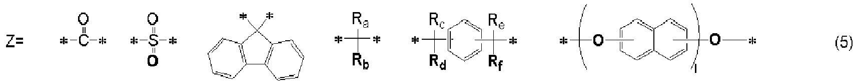 wherein * represents a bonding arm; 1 represents an integer of 0 to 3; and R^{a} to R_{f} each independently represent a hydrogen atom or an optionally fluorine-substituted alkyl group having 1 to 10 carbon atoms, an optionally fluorine-substituted phenyl group, or an optionally fluorine-substituted phenylethyl group, and R^{a} and R_{b} may be bonded to each other to form a cyclic compound, 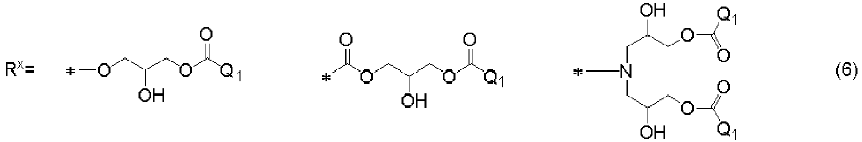 wherein * represents a site bonded with the aromatic ring; and Q₁ is a linear saturated hydrocarbon group having 1 to 30 carbon atoms, or the structure represented by the following general formula (7), 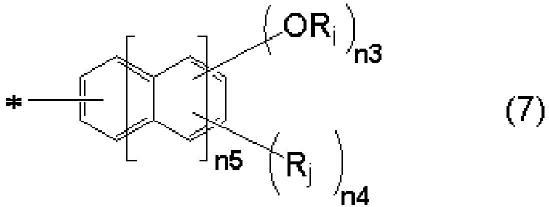 wherein * represents a site bonded with the carbonyl group; and Rᵢ represents a hydrogen atom or the organic group represented by the general formula (2) above, and satisfies a relationship e+f=1 and 0.1≤f≤0.9, wherein "e" represents the proportion of the hydrogen atom and "f" represents the proportion of the organic group represented by the general formula (2) above among the structures constituting Rᵢ; Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; and n₃ and n₄ are each an integer of 0 to 7 that represents the number of substituents on the aromatic ring, provided that n₃ + n₄ is 0 or more and 7 or less; and n₅ represents 0 to 2, 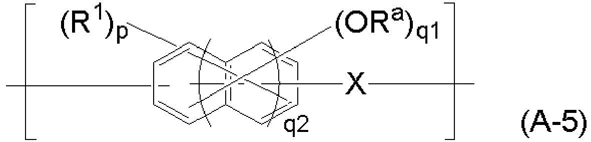 wherein R¹ is a saturated monovalent organic group having 1 to 30 carbon atoms or an unsaturated monovalent organic group having 2 to 30 carbon atoms; X is a divalent organic group having 1 to 30 carbon atoms; and R^{a} is a hydrogen atom or the organic group represented by the general formula (2) above, and satisfies a relationship e+f=1 and 0.1≤f≤0.9, wherein "e" represents the proportion of the hydrogen atom and "f" represents the proportion of the organic group represented by the general formula (2) above among the structures constituting R^{a}; p is an integer of 0 to 5; q₁ is an integer of 1 to 6; p+q₁ is an integer of 1 or more and 6 or less; and q₂ is 0 or 1.

With this wafer edge protection film forming material containing a resin ensuring both high thermal flowability and high dry etching resistance, it is possible to achieve excellent uniform coatability even at a wafer edge portion, which is difficult to coat. Further, the wafer edge can be protected even when a pattern with a high aspect ratio is formed on a substrate to be processed.

Further, the content of the resin (A) in the composition for forming a protection film is preferably 10% by mass or more.

By using such a composition for forming an edge protection film, it is possible to form a thick edge protection film even on a wafer edge portion, which is difficult to coat, thereby providing an edge protection film with a sufficient thickness that can endure the dry etching process on the substrate to be processed.

Further, the composition for forming a protection film preferably further comprises one or more of a crosslinking agent, a high boiling point solvent, a surfactant, an acid generator, and a plasticizer.

By using a composition for forming an edge protection film comprising these additives, various physical properties required for use in the formation of wafer edge protection films, such as defect suppression properties, dry etching resistance, substrate adhesiveness, and the like, can be adjusted within an appropriate range.

Further, in the step (i) above, in addition to the peripheral edge on the surface side of the substrate, the composition for forming a protection film is preferably applied also to the peripheral edge on the backside of the substrate, thereby forming the protection film also on the peripheral edge on the backside of the substrate in the step (ii).

By forming a protection film also on the peripheral edge on the backside using the composition for forming a protection film, it is possible to prevent such a risk that the chemical liquid supplied to the surface of the substrate may run into the peripheral portion on the backside during the formation of a coating film containing a metal, thus forming a coating film also on the peripheral portion on the backside for which formation of a coating film is not intended, resulting in metal contamination in these areas.

Further, the coating in the step (i) is preferably performed using a spin coating method, and the protection film is preferably not formed on areas other than the peripheral edge on the surface side of the substrate and the peripheral edge on the backside of the substrate.

By applying the above composition for forming a protection film by using a spin coating method to form protection films only on the peripheral edges on the surface side and the backside, it is possible to make a significant contribution to improving the productivity of the semiconductor manufacturing process, for example, by reducing consumption of chemical liquids or reducing production time.

Further, in the step (ii), it is preferable to cure the applied composition for forming a protection film by heat treatment at a temperature of 100°C or more and 800°C or less for 10 seconds to 7,200 seconds.

The heat curing enables formation of a dense cured film and improves dry etching resistance.

The present invention also provides a patterning process for forming a protection film on a peripheral edge of a substrate to be processed on which a film with a pattern is formed and forming a pattern on the substrate to be processed, the patterning process comprising the steps of:
(I-1) applying a composition for forming a protection film comprising an aromatic ring-containing resin (A) having an organic group represented by the following general formula (1) and a solvent to a peripheral edge of a substrate to be processed on which a film with a pattern is formed;
(I-2) curing the applied composition for forming a protection film by a heat treatment or optical irradiation to form a protection film on a peripheral edge of the substrate;
(I-3) forming a pattern on the substrate to be processed by dry etching while using the film with a pattern as a mask; and
(I-4) removing the protection film, 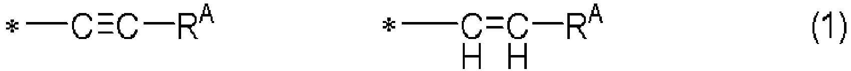
wherein R^{A} is a hydrogen atom or a monovalent organic group having 1 to 10 carbon atoms, and * represents a bonding site.

With the above patterning process, it is possible to suppress particle generation from the wafer edge when the substrate to be processed is dry-etched.

The present invention also provides a patterning process for forming a protection film on a peripheral edge of a substrate to be processed and forming a pattern on the substrate to be processed, the patterning process comprising the steps of:
(II-1) applying a composition for forming a protection film comprising an aromatic ring-containing resin (A) having an organic group represented by the following general formula (1) and a solvent to a peripheral edge of a substrate to be processed;
(II-2) curing the applied composition for forming a protection film by a heat treatment or optical irradiation to form a protection film on a peripheral edge of the substrate to be processed;
(II-3) forming a resist upper layer film pattern on the substrate to be processed and forming a pattern on the substrate to be processed by dry etching while using the resist upper layer film pattern as a mask; and
(II-4) removing the protection film, 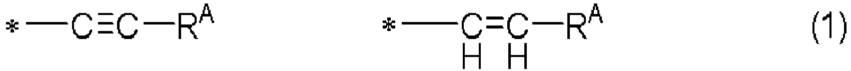
wherein R^{A} is a hydrogen atom or a monovalent organic group having 1 to 10 carbon atoms, and * represents a bonding site.

With the above patterning process, it is possible to suppress particle generation from the wafer edge when the substrate to be processed is dry-etched. Further, it is possible to prevent such a risk that the chemical liquid supplied to the surface of the substrate may run into the peripheral portion on the backside during the formation of a resist upper layer film, thus forming a coating film also on the peripheral portion on the backside for which formation of a coating film is not intended, resulting in contamination in these areas.

Further, in the step (I-1) or (II-1) above, in addition to the peripheral edge on the surface side of the substrate, the composition for forming a protection film is preferably applied also to the peripheral edge on the backside of the substrate, thereby forming the protection film also on the peripheral edge on the backside of the substrate in the step (I-2) or (II-2) above.

By forming a protection film also on the peripheral edge on the backside using the composition for forming a protection film, it is possible to prevent such a risk that the chemical liquid supplied to the surface of the substrate may run into the peripheral portion on the backside during the formation of a coating film containing a metal, thus forming a coating film also on the peripheral portion on the backside for which formation of a coating film is not intended, resulting in metal contamination in these areas.

Further, the present invention also provides a composition for forming a protection film, which is a composition for forming a protection film on a peripheral edge of a substrate, the composition comprising an aromatic ring-containing resin (A) having an organic group represented by the following general formula (1) and a solvent, 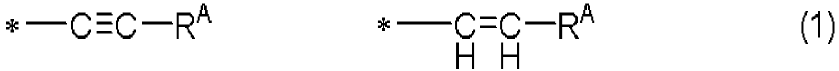 wherein R^{A} is a hydrogen atom or a monovalent organic group having 1 to 10 carbon atoms, and * represents a bonding site.

With this composition for forming a protection film, since the wafer edge protection film forming material containing a resin having an organic group represented by the above general formula (1) with excellent reactivity and thermal flowability and an aromatic ring with excellent dry etching resistance is used, it is possible to achieve excellent uniform coatability even at a wafer edge portion, which is difficult to coat. Further, the wafer edge can be protected even when a pattern with a high aspect ratio is formed on a substrate to be processed.

### ADVANTAGEOUS EFFECTS OF INVENTION

As explained above, the wafer edge protection film forming method and the patterning process of the present invention uses a composition for forming a wafer edge protection film comprising a resin with an aromatic ring-containing structure having an organic group with a specific structure that has excellent thermal flowability, and thus provides a wafer edge protection film having dry etching resistance superior to that of previously-known wafer edge protection films, as well as excellent uniform coatability even at wafer edge portions, which are difficult to coat. In particular, even in dry etching processes for forming fine patterns with high aspect ratios, such as 3D-NAND memory, which is becoming increasingly highly stacked, it is possible to protect wafer edges from the etchant until etching of the substrate to be processed is completed, thereby reducing particle generation from wafer edges due to etching. Thus, the methods are extremely useful in fine patterning process in the semiconductor manufacturing process. Further, by forming a protection film also on the peripheral edge on the backside, it is possible to prevent such a risk that the chemical liquid supplied to the surface of the substrate may run into the peripheral portion on the backside during the formation of a coating film containing a metal, thus forming a coating film also on the peripheral portion on the backside for which formation of a coating film is not intended, resulting in metal contamination in these areas.

### BRIEF DESCRIPTION OF DRAWINGS

FIG. 1 is an explanatory view of a wafer edge.
FIG. 2 is an explanatory view of an example of a wafer edge protection film forming method of the present invention (protecting only the wafer edge on the surface side).
FIG. 3 is another explanatory view of a wafer edge.
FIG. 4 is an explanatory view of another example of a wafer edge protection film forming method of the present invention (protecting only the wafer edge on the surface side and the wafer edge on the backside).
FIG. 5 is an explanatory view of still another example of a wafer edge protection film forming method of the present invention (protecting only the wafer edge on the surface side and the wafer edge on the backside).
FIG. 6 is an explanatory view of an example of patterning process using the wafer edge protection film forming method of the present invention.
FIG. 7 is an explanatory view of another example of patterning process using the wafer edge protection film forming method of the present invention.
FIG. 8 is an explanatory view of a portion of a wafer edge protection film used for film thickness evaluation.
FIG. 9 is an explanatory view of a method for evaluating an amount of surface metallic impurities at a peripheral edge of a wafer.

### DESCRIPTION OF EMBODIMENTS

As described above, wafer edge protection films have been used in the fine patterning process in semiconductor manufacturing process to prevent particle generation from wafer edges during etching, and, in recent semiconductor device manufacturing, more processes of forming patterns with ultra-high aspect ratios on substrates to be processed have been performed with the development of 3D device structures. This has arisen a need to form wafer edge protection films that can endure more complex and lengthy etching processes.

The inventors of the present invention conducted extensive research to solve the above problems, and have sought to form a wafer edge protection film with excellent dry etching resistance and coverage to the wafer edge in the wafer edge protection film forming method. As a result, the inventors found that a wafer edge protection film forming method using a composition for forming a wafer edge protection film containing a resin having an aromatic ring-containing structure with an organic group of a specific structure that has excellent thermal flowability and crosslinking reactivity is very effective for this purpose, and thus completed the present invention.

Specifically, the present invention is a wafer edge protection film forming method for forming a protection film on a wafer edge of a substrate, comprising the steps of (i) coating a peripheral edge of the substrate with a composition for forming a protection film comprising an aromatic ring-containing resin (A) having an organic group represented by the following general formula (1), and a solvent; and (ii) curing the applied composition for forming a protection film by heat or optical irradiation to form the protection film on the peripheral edge of the substrate. 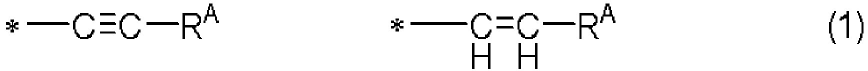 wherein R^{A} is a hydrogen atom or a monovalent organic group having 1 to 10 carbon atoms, and * represents a bonding site.

The present invention is described below in detail; however, the present invention is not limited to the examples described below.

### Wafer Edge Protection Film Forming Method

A protection film is formed on a peripheral edge (wafer edge) of a substrate by applying a composition for forming a protection film on a peripheral edge of a substrate to the peripheral edge of the substrate.

Specifically, a method for forming a protection film on a peripheral edge of a substrate, comprising the steps of:
(i) coating a peripheral edge of the substrate with a composition for forming a protection film comprising an aromatic ring-containing resin (A) having an organic group represented by the general formula (1) described later, and a solvent; and
(ii) curing the applied composition for forming a protection film by heat or optical irradiation to form the protection film on the peripheral edge of the substrate,
is provided.

Such a wafer edge protection film forming method enables formation of a wafer edge protection film that can endure more complex and lengthy etching processes with lower defects.

Examples of the substrate include, but are not particularly limited to, substrates made of Si, α-Si, p-Si, SiO₂, SiN, SiON, W, TiN, Al, and the like, those in which the layers to be processed are formed on the substrate, and the like. Examples of the layers to be processed include various low-k films such as those made of Si, SiO₂, SiON, SiN, p-Si, α-Si, W, W-Si, Al, Cu, or Al-Si, and stopper films thereof, Hf, Zr, Cr, Ge, Ag, Au, In, Ga, As, Pd, Fe, Ta, Co, Mn, Mo, Ru or alloys thereof, amorphous carbon, an organic resist underlayer film, a silicon-containing resist middle layer film, an inorganic hard mask and similar hard masks, which can each be typically formed into a thickness of 50 to 10,000 nm, particularly 100 to 5,000 nm. When the layer to be processed is formed, the substrate and the layer to be processed are made of different materials.

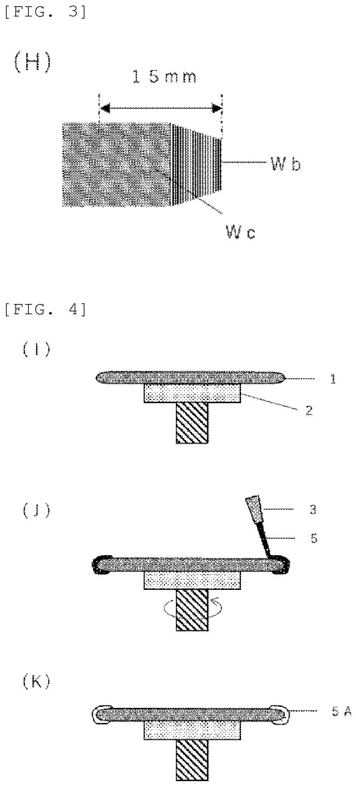

As shown in FIG. 3, for example, the peripheral edge Wc of the substrate is preferably within 15 mm, more preferably within 10 mm, and particularly preferably within 5 mm, from the peripheral edge Wb of the substrate. In this specification, the peripheral edge (wafer edge) of the substrate means the area including the edge surface, the bevel, and the apex, as shown in FIG. 1. Further, the peripheral edge (wafer edge) of the substrate may include the backside of the edge, in which case these peripheral edges are referred to as the peripheral edge on the surface side and the peripheral edge on the backside.

The protection film forming method using the composition for forming a wafer edge protection film of the present invention enables formation of a protection film on a peripheral edge on the surface side of a substrate by applying a composition for forming a protection film on a peripheral edge on the surface side of a substrate.

As shown in FIG. 2(E), in the step (i), a wafer (substrate) 1 is first placed on a rotatable spin chuck 2. The method of applying the above composition for forming a protection film to a substrate is not particularly limited, and any appropriate coating means, for example, a spin coating method of continuously discharging a coating liquid onto a substrate that is under rotation at a constant speed, a spray method of spraying a coating liquid onto the surface of a substrate, and the like, can be employed. In the present embodiment, the spin coating method is used as a means for applying the composition for forming a protection film to the peripheral edge on the surface side of the wafer 1. Specifically, as shown in FIG. 2(F), the composition for forming a protection film 4 is applied to the peripheral edge on the surface side of the wafer 1 while rotating the spin chuck 2 at a rotation rate according to the viscosity of the composition for forming a protection film 4 and the desired coating film thickness. The composition for forming a protection film 4 is discharged from the top end of a supply nozzle 3 for supplying the composition for forming a protection film 4 from above to the peripheral edge on the surface side of the wafer 1, which is rotating around a vertical axis in a horizontal plane. Then, in the step (ii), a protection film 4A is formed on the peripheral edge on the surface side, as shown in FIG. 2(G).

The wafer edge protection film forming method of the present invention may be a method of forming a protection film on the peripheral edge (wafer edge) of a substrate in which a resist upper layer film pattern is formed on a substrate to be processed, or a method of forming a wafer edge protection film on a substrate to be processed, applying a resist upper layer film, and then subjecting it to exposure to light to form a resist upper layer film pattern. Alternatively, a method for forming a resist upper layer film pattern using a multilayer resist method, typified by the three-layer resist process in which a wafer edge protection film is formed on a substrate to be processed, a resist underlayer film, an inorganic hard mask, and the like are formed, and a resist upper layer film is formed thereon, may be used. Since the resist upper layer film in which a pattern is formed is used as a mask to process the substrate to be processed, it is preferable if the protection film can be formed on the wafer edge using the composition for forming a wafer edge protection film before dry etching is started, since it can suppress particle generation from the wafer edge.

In the case of coating a peripheral edge of a substrate, the applied protection film may be dried by rotating the spin chuck at, for example, 10 to 4000 rpm.

The wafer edge protection film forming method of the present invention also enables formation of a protection film on a peripheral edge on the surface side and a peripheral edge on the backside of a substrate by applying a composition for forming a protection film for forming a protection film on a peripheral edge on the surface side and a peripheral edge on the backside of a substrate.

As shown in FIG. 4(I), in the step (i), a wafer (substrate) 1 is first placed on a rotatable spin chuck 2. The method of applying the above composition for forming a protection film to a substrate is not particularly limited, and any appropriate coating means, for example, a spin coating method of continuously discharging a coating liquid onto a substrate that is under rotation at a constant speed, a spray method of spraying a coating liquid onto the surface of a substrate, and the like, can be employed. In the present embodiment, the spin coating method is used as a means for applying the composition for forming a protection film to the peripheral edge on the surface side and the peripheral edge on the backside of the wafer 1. Specifically, as shown in FIG. 4(J), the composition for forming a protection film 5 is applied to the peripheral edge on the surface side and the peripheral edge on the backside of the wafer 1 while rotating the spin chuck 2 at a rotation rate according to the viscosity of the composition for forming a protection film 5 and the desired coating film thickness. The composition for forming a protection film 5 is discharged from the top end of the supply nozzle 3 for supplying the composition for forming a protection film 5 from above to the peripheral edge on the surface side and the peripheral edge on the backside of the wafer 1, which is rotating around a vertical axis in a horizontal plane. Then, in the step (ii), a protection film 5A is formed on the peripheral edge on the surface side and the peripheral edge on the backside, as shown in FIG. 4(K).

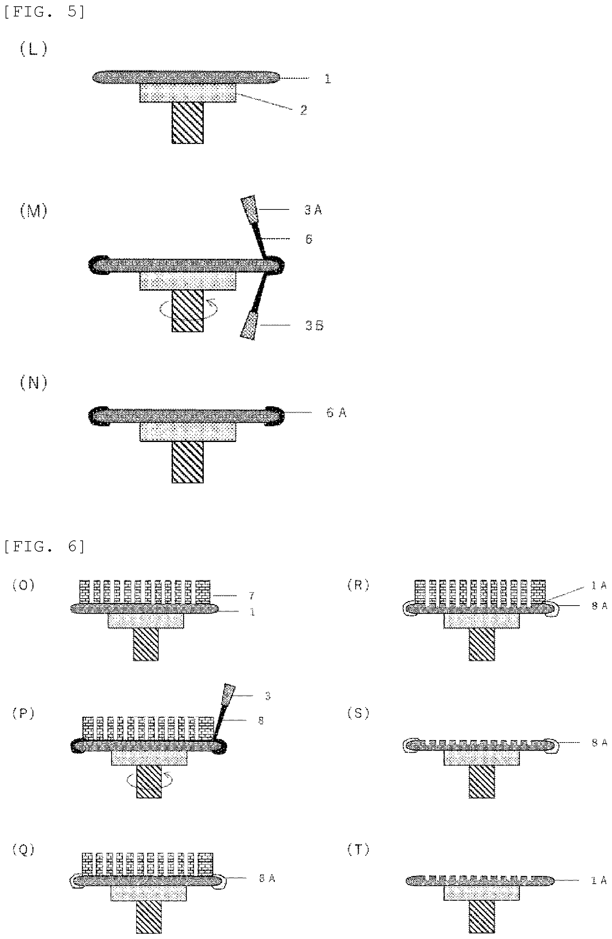

In the case of coating the peripheral edge on the surface side and the peripheral edge on the backside of the substrate, the composition for forming a protection film may be supplied from separate supply nozzles respectively to peripheral edge on the surface side and the peripheral edge on the backside. For example, in the embodiment shown in FIG. 5, as shown in FIG. 5(L), after the wafer 1 is placed on the spin chuck 2, as shown in FIG. 5(M), the composition for forming a protection film 6 is discharged from the top ends of an upper supply nozzle 3A and a lower supply nozzle 3B for supplying the composition for forming a protection film 6 from above and below to the peripheral edge on the surface side and the peripheral edge on the backside of the wafer 1 under rotation, and a protection film 6A is formed on the peripheral edge on the surface side and the peripheral edge on the backside, as shown in FIG. 5(N). Further, the applied protection film 6A may be dried by rotating the spin chuck 2 at, for example, 10 to 4000 rpm.

The lower limit of the average thickness of the protection film described above is preferably 100 nm, more preferably 200 nm, for the surface portion. The lower limit is preferably 100 nm, more preferably 200 nm, for the bevel portion. The lower limit is preferably 200 nm, more preferably 300 nm, for the apex portion. The lower limit is preferably 1 nm, more preferably 5 nm, for the backside portion.

The upper limit of the average thickness of the protection film described above is preferably 5,000 nm, more preferably 4,000 nm, for the surface portion. The upper limit is preferably 5,000 nm, more preferably 4,000 nm, for the bevel portion. The upper limit is preferably 7,000 nm, more preferably 6,000 nm, for the apex portion. The upper limit is preferably 1,000 nm, more preferably 500 nm, for the backside portion.

The thickness of the wafer edge protection film described above can be appropriately selected according to the purpose of edge protection. However, if the thickness falls within the above range, it is possible to provide a method for forming a wafer edge protection film that can endure more complex and lengthy etching processes, typified by the process for forming patterns having an ultra-high aspect ratio.

The wafer edge protection film forming method of the present invention is preferably a method of forming a wafer edge protection film only on the peripheral edge on the surface side and the peripheral edge on the backside of the substrate. With this method, it is possible to, for example, reduce the consumption of the chemicals for the composition for forming a wafer edge protection film or simplify the protection film forming process and the protection film removal process, thereby contributing to the rationalization of the semiconductor manufacturing process.

In the wafer edge protection film forming method of the present invention, the composition for forming a wafer edge protection film applied onto the peripheral edge on the surface side and the peripheral edge on the backside of the substrate is cured by heat or optical irradiation. In particular, a heat curing method is more preferable from the viewpoint of dry etching resistance.

To perform heat-curing of the composition for forming a wafer edge protection film applied to the peripheral edge on the surface side and the peripheral edge on the backside of the substrate, the composition for forming a protection film described above is preferably subjected to a heat treatment at a temperature of 100°C or more and 800°C or less, preferably 150°C or more and 600°C or less, for 10 to 7,200 seconds, preferably 10 to 600 seconds, thereby forming a protection film. From the viewpoint of reducing sublimates of the composition for forming a wafer edge protection film, a temperature of 100°C or more and 450°C or less is more preferable, and from the viewpoint of productivity, the heat treatment for 10 to 300 seconds is more preferable.

The above temperature range is preferable because a wafer edge protection film with excellent dry etching resistance can be formed, also because defects including mixing of the wafer edge protection film and the resist film and peel-off of the protection film by an edge cut rinse, such as PGMEA, can be prevented when a coating type material, such as a photoresist, is applied to a substrate to be processed on which a wafer edge protection film is formed.

When the composition for forming a wafer edge protection film applied to the peripheral edge on the surface side and the peripheral edge on the backside of the substrate is cured by optical irradiation, the light used for the curing is not particularly limited, and examples include light or radiation having a wavelength in the range of high energy ionizing radiation, near ultraviolet light, far ultraviolet light, visible light, infrared ray, and the like. As the radiation, for example, microwave, EUV, LED, semiconductor laser, or laser light for use in microfabrication of optical semiconductors, such as 248-nm KrF excimer laser or 193-nm ArF excimer laser, and the like, can also be suitably used.

These rays may be monochrome rays or multiple rays of different wavelengths (mixed light). The wavelength of the light may be, for example, in a range of about 150 to 800 nm, preferably in a range of about 150 to 600 nm, further preferably in a range of about 150 to 400 nm. The irradiation light amount (irradiation energy) is not particularly limited, and may be, for example, in a range of about 1 to 10,000 mW, preferably in a range of about 5 to 5,000 mW, further preferably in a range of about 10 to 1,000 mW. The irradiation time is also not particularly limited, and may be in a range of about 5 seconds to 60 minutes, preferably in a range of about 10 seconds to 30 minutes, and further preferably in a range of about 30 seconds to 10 minutes.

A heat treatment and optical irradiation may be used in combination.

The formation of a uniform film is more difficult in the coating on wafer edges compared with the coating on wafer surfaces; therefore, excellent film forming property is required for a composition for forming a wafer edge protection film. In contrast, according to the wafer edge protection film forming method of the present invention, since the aromatic ring-containing resin (A) having an organic group represented by the above general formula (1) is used to protect the peripheral edges of the substrate to be processed, the roughness of the film generated during the coating can be recovered by the thermal flow; thus, a wafer edge protection film forming method with excellent uniform coatability can be provided.

### Composition for Forming Wafer Edge Protection Film

The composition for forming a wafer edge protection film of the present invention comprises an aromatic ring-containing resin (A) having an organic group represented by the following general formula (1) and a solvent, 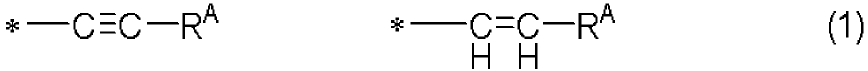 wherein R^{A} is a hydrogen atom or a monovalent organic group having 1 to 10 carbon atoms, and * represents a bonding site.

### (A) Resin

Since the resin (A) described above has the organic group represented by the above general formula (1), thermal flowability is improved and excellent uniform coatability can be achieved even at a wafer edge portion, which is difficult to coat. Further, since the resin (A) contains an aromatic ring, excellent dry etching resistance can be obtained, and it is possible to protect wafer edges even in the case of forming a pattern with a high aspect ratio on a substrate to be processed.

In the above general formula (1), R^{A} is a hydrogen atom or a monovalent organic group having 1 to 10 carbon atoms, and is preferably a hydrogen atom or a structure represented by the following formula (R^{a}-1) from the viewpoint of thermosetting property and flowability. 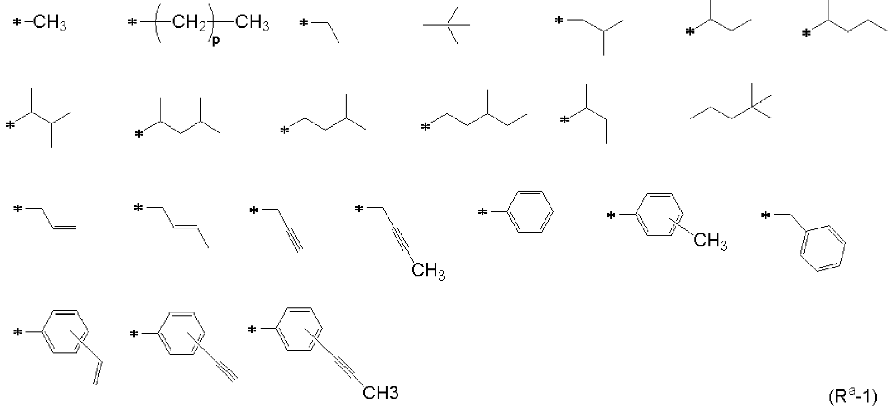 wherein * denotes a bonding site; p is 1 to 9, preferably 1 to 6.

The resin (A) preferably also has a hydroxyl group, and the ratio of the number of the hydroxyl groups to the number of the organic groups represented by the general formula (1) above preferably satisfies a relationship a+b=1 and 0.1≤b≤0.9, more preferably 0.2≤b≤0.8, further preferably 0.3≤b≤0.7, wherein "a" represents the proportion of the hydroxyl group and "b" represents the proportion of the organic group represented by the general formula (1) above.

By controlling the ratio between the hydroxyl group and the organic group represented by the above general formula (1) within the above range, it is possible to achieve high thermal flowability and high substrate adhesiveness, thus providing a composition for forming a wafer edge protection film with excellent wafer edge coverage and excellent defect suppression property. In order to improve the adhesiveness of the film with respect to the substrate, the proportion "a" of the hydroxyl group may be increased, that is, a>b may be satisfied, and in order to improve the curability, the heat resistance, and the defect suppression property, a<b may be satisfied. These proportions can be arbitrarily adjusted according to the required performance.

The above resin (A) is preferably an aromatic ring-containing resin having a hydroxyl group and an organic group represented by the following general formula (1A). 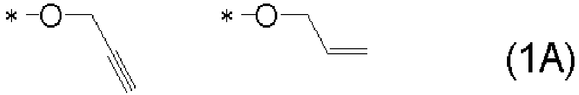 wherein * represents a bonding site.

With the organic group represented by the above general formula (1A), thermal flowability can be improved and excellent uniform coatability can be achieved even at a wafer edge portion, which is difficult to coat. Further, with the oxygen atoms therein, solubility in organic solvents can be improved.

The ratio of the number of the hydroxyl groups to the number of the organic groups represented by the general formula (1A) above contained in the resin (A) above preferably satisfies a relationship c+d=1 and 0.1≤d≤0.9, more preferably 0.2≤d≤0.8, further preferably 0.3≤d≤0.7, wherein "c" represents the proportion of the hydroxyl group and "d" represents the proportion of the organic group represented by the general formula (1A) above.

By controlling the ratio between the hydroxyl group and the above general formula (1A) within the above range, it is possible to achieve high thermal flowability and high substrate adhesiveness, thus providing a composition for forming a wafer edge protection film with excellent wafer edge coverage and excellent defect suppression property. In order to improve the adhesiveness of the film with respect to the substrate, the proportion "c" of the hydroxyl group may be increased, that is, c>d may be satisfied, and in order to improve the curability, the heat resistance, and the defect suppression property, c<d may be satisfied. These proportions can be arbitrarily adjusted according to the required performance.

In the resin (A) above, the ratio Mw/Mn (i.e., dispersity) of the weight average molecular weight Mw to the number average molecular weight Mn on polystyrene basis according to gel permeation chromatography is preferably within a range of 1.00≤Mw/Mn≤1.25, more preferably in a range of 1.00≤Mw/Mn≤1.10. By definition, Mw/Mn is 1.00 for a monomolecular compound; however, the measured value may exceed 1.00 because of the separation property of GPC. In general, it is extremely difficult for polymers with repeating units to approach Mw/Mn = 1.00 unless a special polymerization method is used; therefore, they have Mw distribution and Mw/Mn of more than 1. In the present invention, 1.00≤Mw/Mn≤1.10 is defined as an index of monomolecularity to distinguish monomolecular compounds from polymeric compounds.

With a compound having a dispersity in this range, the thermal flowability of the composition for forming a wafer edge protection film is further improved, thus providing a composition for forming a wafer edge protection film having excellent wafer edge coverage and excellent defect suppression property when the compound is blended in a material.

The resin (A) above is preferably a polymer having a weight average molecular weight on polystyrene basis according to gel permeation chromatography of 1,000 to 12,000, more preferably 2,000 to 10,000.

When the molecular weight falls within this range, solubility in an organic solvent can be ensured, thereby suppressing sublimates generated during the baking. Further, the thermal flowability of the composition for forming a wafer edge protection film can be improved, thus providing a composition for forming a wafer edge protection film having excellent wafer edge coverage and excellent defect suppression property when the compound is blended in a material.

The resin (A) above preferably has at least one of the constituent units represented by the following general formulae (A-1), (A-2), (A-3), (A-4), and (A-5).

### Constituent Unit: A-1, A-2 and A-3

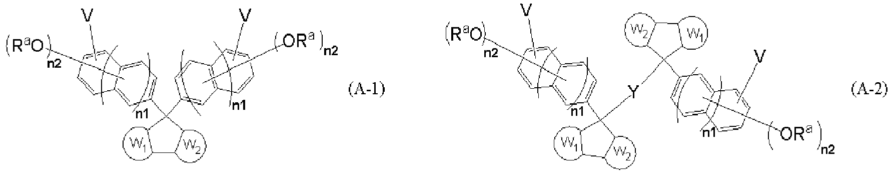

In the formula, W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} is a hydrogen atom or an organic group represented by the following general formula (2), and satisfies a relationship e+f=1 and 0.1≤f≤0.9, wherein "e" represents the proportion of the hydrogen atom and "f" represents the proportion of the organic group represented by the general formula (2) above among the structures constituting R^{a}. Y is a group represented by the following general formula (3); n₁ is 0 or 1; n₂ is 1 or 2; and V independently represents a hydrogen atom or a connection portion.

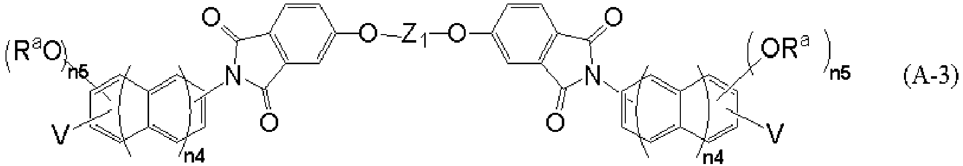

In the formula, Z₁ is a group represented by the following general formula (4), and R^{a} is a hydrogen atom or an organic group represented by the following general formula (2) and satisfies a relationship e+f=1 and 0.1≤f≤0.9, wherein "e" represents the proportion of the hydrogen atom and "f" represents the proportion of the organic group represented by the general formula (2) above among the structures constituting R^{a}; n₄ is 0 or 1; n₅ is 1 or 2; and V independently represents a hydrogen atom or a connection portion.

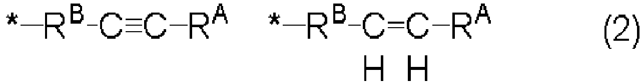

In the formula, * represents a site bonded with the oxygen atom; R^{B} is a divalent organic group having 1 to 10 carbon atoms; and R^{A} is a hydrogen atom or a monovalent organic group having 1 to 10 carbon atoms.

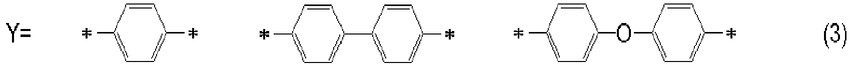

In the formula, * represents a bonding arm,

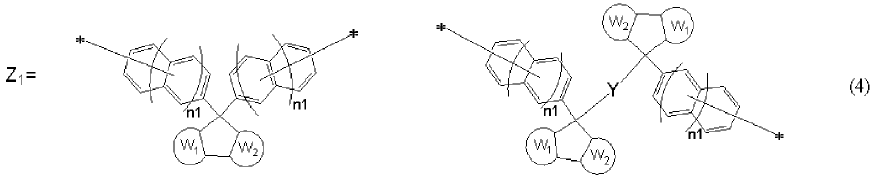

In the formula, W₁, W₂, Y, and n₁ are as defined above.

If the resin has at least one of the constituent units represented by the above general formulae (A-1), (A-2), and (A-3), a condensed carbon ring with a high carbon density including a cardo structure is introduced therein, thus forming a wafer edge protection film with excellent dry etching resistance and excellent heat resistance. Because of the features described above, it becomes possible to protect wafer edges from dry etching process by forming a thinner protection film, which is desirable from the viewpoint of productivity and production cost for the composition for forming a wafer edge protection film.

In the above general formulas (A-1), (A-2) and (A-3), R^{a} represents a hydrogen atom or an organic group represented by the above general formula (2), and the above general formula (2) is preferably the structure represented by the following general formula (2-A), 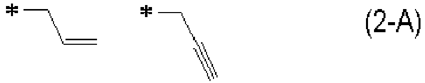 wherein * represents a site bonded with the oxygen atom.

With the above general formulas (A-1), (A-2), and (A-3) having an organic group represented by the above general formula (2), in particular, an organic group represented by the above general formula (2-A), thermal flowability can be further improved, and, even at a wafer apex portion, which is difficult to coat, excellent uniform coatability that suppresses defects, such as liquid pillar or crater, can be achieved.

The ratio of the number of the hydroxyl groups to the number of the organic groups represented by the general formula (2) above contained in the above general formulae (A-1), (A-2), and (A-3) preferably satisfies a relationship e+f=1 and 0.1≤f≤0.9, more preferably 0.2≤f≤0.8, further preferably 0.3≤f≤0.7, wherein "e" represents the proportion of the hydroxyl group and "f" represents the proportion of the organic group represented by the above general formula (2).

By controlling the ratio between the hydroxyl group and the above general formula (2) within the above range, it is possible to achieve high thermal flowability and high substrate adhesiveness, thus providing a composition for forming a wafer edge protection film with excellent wafer edge coverage and excellent defect suppression property. In order to improve the adhesiveness of the film with respect to the substrate, the proportion "e" of the hydroxyl group may be increased, that is, e>f may be satisfied, and in order to improve the curability, the heat resistance, and the defect suppression property, e<f may be satisfied. These proportions can be arbitrarily adjusted according to the required performance.

Further, in the resin with the constituent units represented by the above general formulae (A-1), (A-2), and (A-3), by the action of the cardo structure introduced into the molecule, the interaction between the molecules is alleviated and the solubility in an organic solvent is imparted; therefore, the film forming property at the time of forming a coating film is improved. Further, because of the introduction of a plurality of condensed carbon rings with a high carbon density, a wafer edge protection film with excellent heat resistance characteristics and excellent dry etching resistance can be formed.

The resins having the constituent units represented by the above general formulae (A-1), (A-2) and (A-3) may be compounds represented by the following general formulae (a-1) and/or (a-2) and/or (a-3).

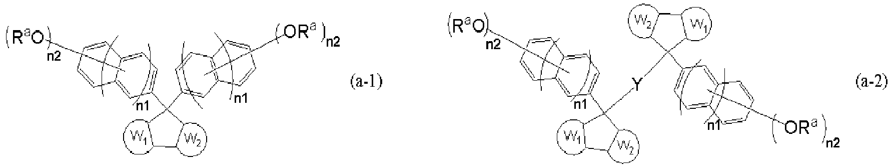

In the above general formulae (a-1) and (a-2), W₁, W₂, R^{a}, Y, n₁ and n₂ are as defined above.

In the above general formulae (a-1) and (a-2), W₁, W₂, R^{a}, Y, n₁ and n₂ are as defined above for the above general formulae (A-1) and (A-2). 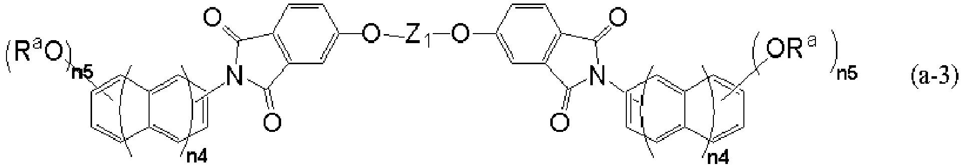 In the above general formula (a-3), Z₁, R^{a}, n₄ and n₅ are as defined above.

In the above general formula (a-3), Z₂, R^{a}, n₄ and n₅ are as defined above for the above general formula (A-3) .

Specific examples of the resins having constituent units represented by the above general formulae (a-1), (a-2) and (a-3) include, but are not limited to, the following compounds.

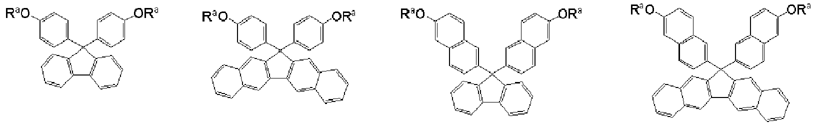

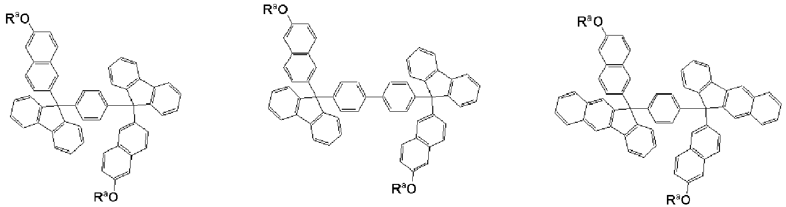

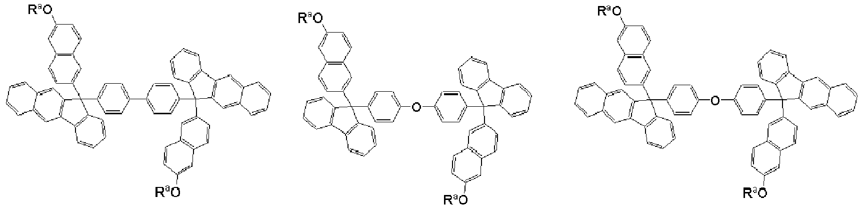

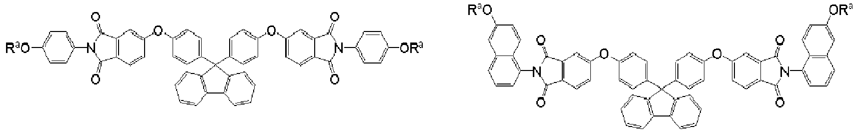

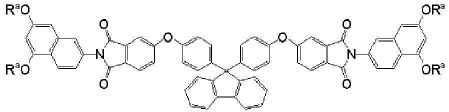

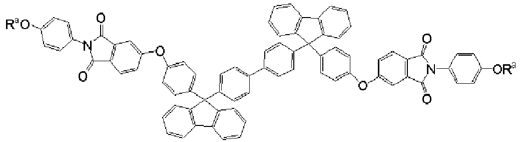

In the resins (a-1), (a-2) and (a-3) above, the ratio Mw/Mn (i.e., dispersity) of the weight average molecular weight Mw to the number average molecular weight Mn on polystyrene basis according to gel permeation chromatography is preferably within a range of 1.00≤Mw/Mn≤1.25, more preferably in a range of 1.00≤Mw/Mn≤1.10.

With a compound having a dispersity in this range, the thermal flowability of the composition for forming a wafer edge protection film is further improved, thus providing a composition for forming a wafer edge protection film having excellent wafer edge coverage and excellent defect suppression property when the compound is blended in a material.

The resins having the constituent units represented by the above general formulae (A-1), (A-2) and (A-3) may be polymers having repeating units represented by the following general formulae (a-4) and/or (a-5) and/or (a-6) .

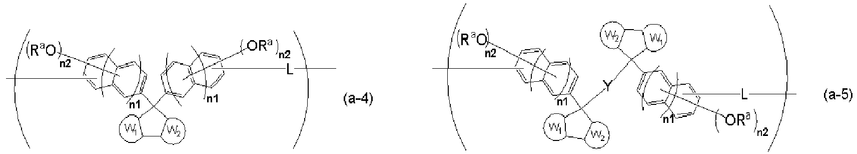

In the above general formulae (a-4) and (a-5), W₁, W₂, R^{a}, Y, n₁ and n₂ are as defined above, and L is a divalent organic group having 1 to 40 carbon atoms.

In the above general formulae (a-4) and (a-5), W₂, W₂, R^{a}, Y, n₁ and n₂ are as defined above for the above general formulae (A-1) and (A-2).

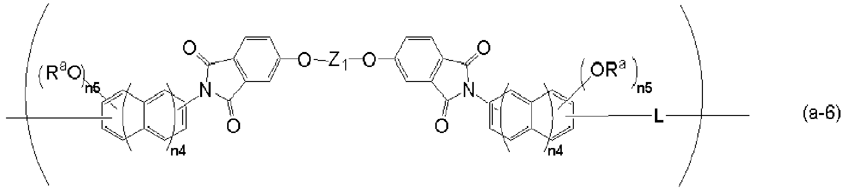

In the above general formula (a-6), Z₁, R^{a}, n₄ and n₅ are as defined above, and L is a divalent organic group having 1 to 40 carbon atoms.

In the above general formula (a-6), Z₁, R^{a}, n₄ and n₅ are as defined above for the above general formula (A-3) .

These are polymers obtained by using the compounds represented by the above general formulae (a-1), (a-2) and (a-3), and are excellent in dry etching resistance and heat resistance because the compounds described above are used. In addition, since the polymer is not a monomer but a polymer having repeating units, the amount of outgas component is small, and the polymer has a molecular weight distribution; therefore, crystallinity is alleviated, and improved film forming property can be expected.

L, which is a linkage group constituting the repeating units of the above general formulae (a-4), (a-5) and (a-6), is a divalent organic group having 1 to 40 carbon atoms. Specific examples thereof include the following.

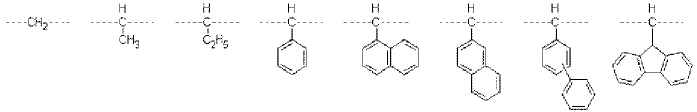

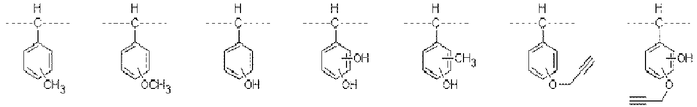

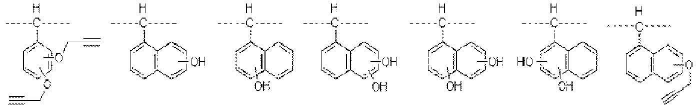

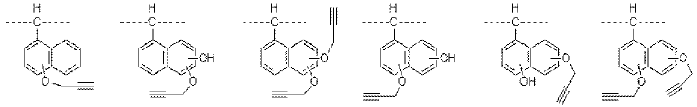

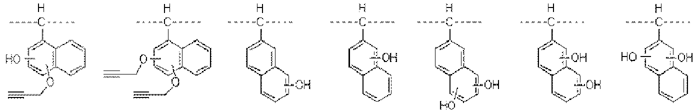

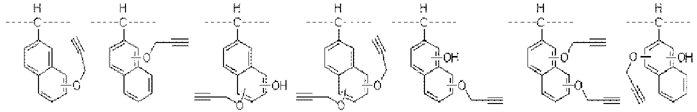

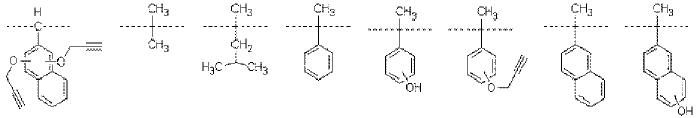

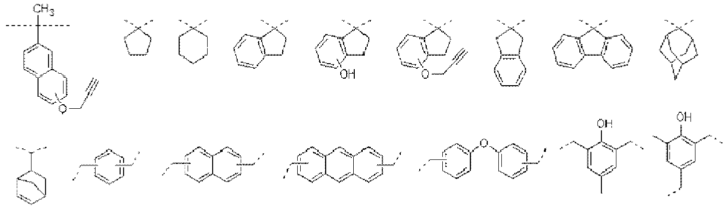

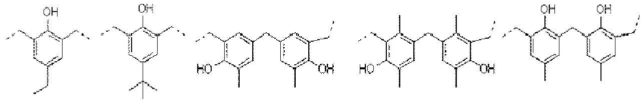

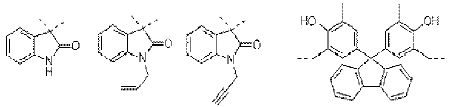

Further, the linkage group L of the polymer described above is preferably represented by the following general formula (10), 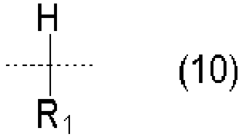 wherein R¹ is a hydrogen atom or an organic group having an aromatic ring having 1 to 20 carbon atoms, and the dashed line represents a bonding arm.

Specific examples of those represented by the general formula (10) above include the following; among these, a methylene group is preferable because of easy obtainability of the material, i.e., R¹ is preferably a hydrogen atom.

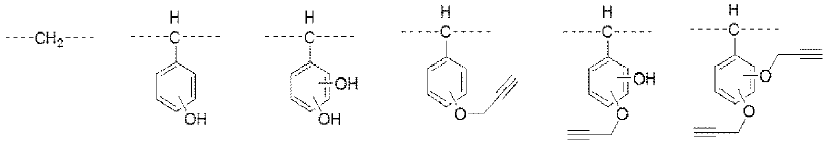

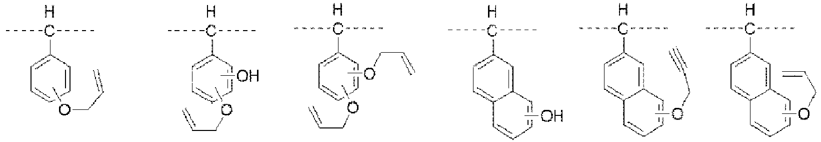

Further, the weight average molecular weight on polystyrene basis according to gel permeation chromatography of the polymer having the repeating structure units represented by the above general formulae (a-4), (a-5) and (a-6) is preferably 1,000 to 12,000; and Mw is preferably 2,000 to 10,000.

When the molecular weight falls within this range, solubility in an organic solvent can be ensured, thereby suppressing sublimates generated during the baking. Further, the thermal flowability of the composition for forming a wafer edge protection film can be improved, thus providing a composition for forming a wafer edge protection film having excellent wafer edge coverage and excellent defect suppression property when the compound is blended in a material.

The resin containing the constituent units represented by the above general formulae (A-1), (A-2), and (A-3) has a high carbon density because of its backbone structure including a cardo structure. Accordingly, the composition for forming a wafer edge protection film containing these compounds exhibits extremely high dry etching resistance and has excellent heat resistance. Further, because of the content of the organic group represented by the above general formula (2), which contributes to the improvement of thermal flowability, it is possible to provide a composition for forming a wafer edge protection film with excellent wafer edge coverage and excellent defect suppression property. With the compound having structures represented by the above general formulae (a-1), (a-2) and (a-3), the thermal flowability of the composition for forming a wafer edge protection film is further improved, thus providing a composition for forming a wafer edge protection film having excellent wafer edge coverage and excellent defect suppression property when the compound is blended in a material. On the other hand, with the polymer containing the constituent units with the structures represented by the above general formulae (a-4), (a-5), and (a-6), it is possible to suppress the generation of sublimates during the baking and provide a wafer edge protection film with excellent film thickness uniformity. By mixing the compound having the structures represented by the above general formulae (a-1), (a-2), and (a-3) with the polymer containing the constituent units represented by the above general formulae (a-4), (a-5), and (a-6), it is possible to provide a composition for forming a wafer edge protection film satisfying the required properties. As described above, the composition for forming a wafer edge protection film obtained by using the resins containing constituent units represented by the above general formulae (A-1), (A-2) and (A-3) can achieve both film forming property and heat resistance/etching resistance at significantly high levels.

### Constituent Unit: A-4

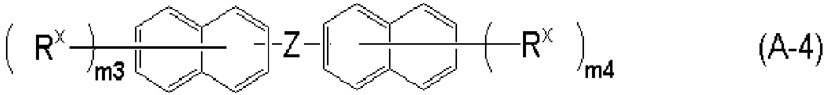

In the formula, m₃ and m₄ represent 1 or 2; and Z represents either a single bond or the structure represented by the following general formula (5). R^{X} is any one of the structures represented by the following general formula (6).

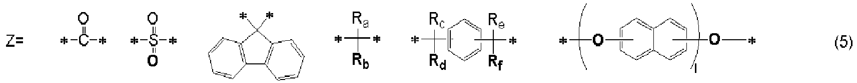

In the formula, * represents a bonding arm; l represents an integer of 0 to 3; and R^{a} to R_{f} each independently represent a hydrogen atom or an optionally fluorine-substituted alkyl group having 1 to 10 carbon atoms, an optionally fluorine-substituted phenyl group, or an optionally fluorine-substituted phenylethyl group, and R^{a} and R_{b} may be bonded to each other to form a cyclic compound.

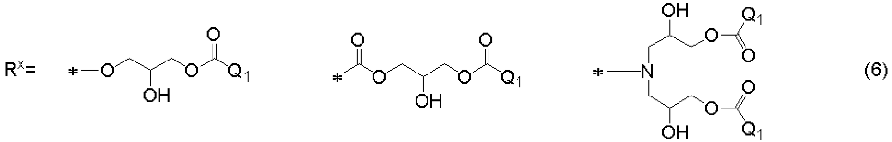

In the formula, * represents a site bonded with the aromatic ring; and Q₁ is a linear saturated hydrocarbon group having 1 to 30 carbon atoms, or the structure represented by the following general formula (7).

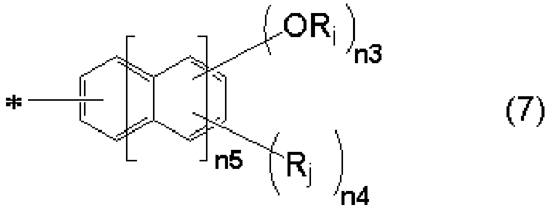

In the formula, * represents a site bonded with the carbonyl group; and Rᵢ represents a hydrogen atom or the organic group represented by the general formula (2) above, and satisfies a relationship e+f=1 and 0.1≤f≤0.9, wherein "e" represents the proportion of the hydrogen atom and "f" represents the proportion of the organic group represented by the general formula (2) above among the structures constituting Rᵢ; Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; and n₃ and n₄ are each an integer of 0 to 7 that represents the number of substituents on the aromatic ring, provided that n₃ + n₄ is 0 or more and 7 or less; and n₅ represents 0 to 2.

From the viewpoint of dry etching resistance and heat resistance, in the above general formula (A-4), Z is preferably either a single bond or the structure represented by the following formula (4A), 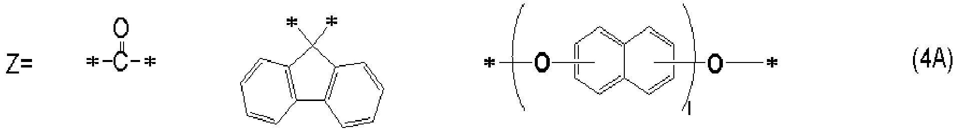 wherein * represents a bonding arm and 1 is as defined in the above formula (5).

In the above general formula (6), * represents a site bonded with the aromatic ring, and Q₁ is a linear saturated hydrocarbon group having 1 to 30 carbon atoms, or the structure represented by the above general formula (7). When Q₁ represents a linear hydrocarbon group having 1 to 30 carbon atoms, the methylene group constituting Q₁ may be substituted with an oxygen atom or a carbonyl group. From the viewpoint of dry etching resistance and heat resistance, Q₁ is preferably the structure represented by the above general formula (7).

Since the above general formula (A-4) has the organic group represented by the above general formula (2), in particular, the organic group represented by the above general formula (2-A), thermal flowability can be improved and excellent uniform coatability can be achieved even at a wafer edge portion, which is difficult to coat.

The ratio of the number of the hydroxyl groups to the number of the organic groups represented by the general formula (2) above contained in the above general formula (A-4) preferably satisfies a relationship e+f=1 and 0.1≤f≤0.9, more preferably 0.2≤f≤0.8, further preferably 0.3≤f≤0.7, wherein "e" represents the proportion of the hydroxyl group and "f" represents the proportion of the organic group represented by the above general formula (2).

By controlling the ratio between the hydroxyl group and the above general formula (2) within the above range, it is possible to achieve high thermal flowability and high substrate adhesiveness, thus providing a composition for forming a wafer edge protection film with excellent wafer edge coverage and excellent defect suppression property. In order to improve the adhesiveness of the film with respect to the substrate, the proportion "e" of the hydroxyl group may be increased, that is, e>f may be satisfied, and in order to improve the curability, the heat resistance, and the defect suppression property, e<f may be satisfied. These proportions can be arbitrarily adjusted according to the required performance.

The compound containing the constituent unit represented by the above general formula (A-4) has a high carbon density because of its structure in which aromatic rings are linked via a single bond or via the general formula (5). Accordingly, the composition for forming a wafer edge protection film containing these compounds exhibits high dry etching resistance and has excellent heat resistance. Further, as shown in the above general formula (5), the structure of the linkage group Z can be selected from various linkage groups according to the desired performance. In particular, by introducing the structure represented by the above general formula (4A) as Z, heat resistance/etching resistance can be imparted without impairing film forming property. Further, by having the end portion R^{x} with high flexibility, it is possible to form a thick protection film on a wafer edge without generating cracks or other defects, even though the content of a rigid aromatic ring structure. Further, the end portion R^{x} contains a terminal group Q₁ that imparts thermal flowability. As the terminal group Q₁, a flexible hydrocarbon structure that contributes to improvement in thermal flowability and a rigid aromatic ring structure that contributes to etching resistance and heat resistance can be introduced in arbitrary proportions according to the required performance. As described above, the composition for forming a wafer edge protection film formed from these compounds can achieve both film forming property and heat resistance/etching resistance at high levels, thus allowing formation of a thick film according to the required characteristics.

### Constituent Unit: A-5

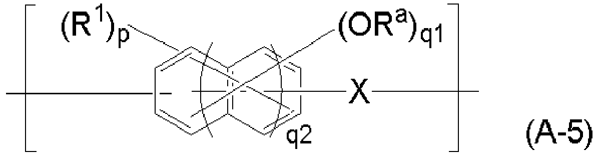

In the formula, R¹ is a saturated monovalent organic group having 1 to 30 carbon atoms or an unsaturated monovalent organic group having 2 to 30 carbon atoms; X is a divalent organic group having 1 to 30 carbon atoms; and R^{a} is a hydrogen atom or the organic group represented by the general formula (2) above, and satisfies a relationship e+f=1 and 0.1≤f≤0.9, wherein "e" represents the proportion of the hydrogen atom and "f" represents the proportion of the organic group represented by the general formula (2) above among the structures constituting R^{a}; p is an integer of 0 to 5, q₁ is an integer of 1 to 6, p+q₁ is an integer of 1 or more and 6 or less, and is 0 or 1.

In the above general formula (A-5), examples of the divalent organic group having 1 to 30 carbon atoms represented by X include alkanediyl groups such as methylene group, ethanediyl group, propanediyl group, butanediyl group, pentanediyl group, hexanediyl group, octanediyl group, decanediyl group, and the like; monocyclic cycloalkanediyl groups such as cyclopropanediyl group, cyclobutanediyl group, cyclopentanediyl group, cyclohexanediyl group, cycloheptanediyl group, cyclooctanediyl group, cyclodecanediyl group, methylcyclohexanediyl group, ethylcyclohexanediyl group, and the like; polycyclic cycloalkanediyl group such as bicyclo[2.2.1]heptanediyl group, bicyclo[2.2.2]octanediyl group, tricyclo[5.2.1.0^{2,6}] decanediyl group (dicyclopentylene group), tricyclo[3.3.1.1^{3,7}] decanediyl group, tetracyclo[6.2.1.1^{3,6}.0^{2,7}] dodecanediyl group, adamantanediyl group, and the like; and arenediyl group such as phenylene group, naphthylene group, and the like.

Examples of the alkanediyloxy group represented by X above include a group combining the above alkanediyl group and an oxygen atom, and the like. Examples of the cycloalkanediyloxy group represented by X above include a group combining the above cycloalkanediyl group and an oxygen atom, and the like.

Some or all of the hydrogen atoms in the above alkanediyl group, cycloalkanediyl group, alkanediyloxy group, cycloalkanediyloxy group, arenediyl group and the like may be substituted. Examples of the substituent include halogen atoms such as fluorine atom, chlorine atom, bromine atom, iodine atom, and the like; hydroxyl group, cyano group, carboxy group, nitro group, amino group, alkoxy group, alkoxycarbonyl group, acyl group, alkoxycarbonyloxy group, aryl group, aliphatic heterocyclic group such as lactone group, and the like; and aromatic heterocyclic groups such as furyl group, pyridyl group, and the like.

Examples of the organic group represented by X above include the groups represented by the following formulae, and the like, 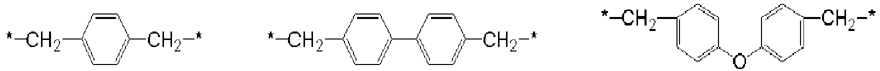 wherein * represents a bonding arm.

The X above is preferably a methylene group from the viewpoint of availability of raw materials.

Specific examples of the resin having the structure unit represented by the above general formula (A-5) include the following resins.

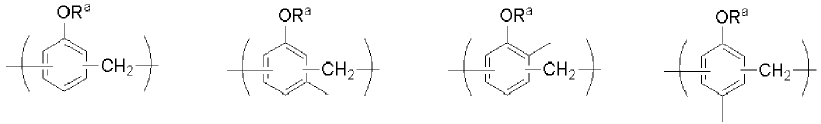

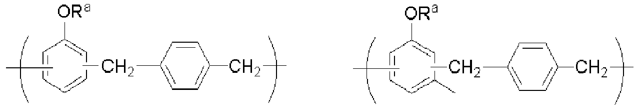

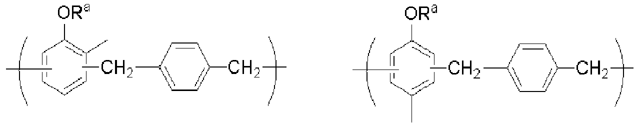

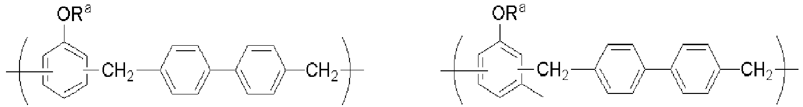

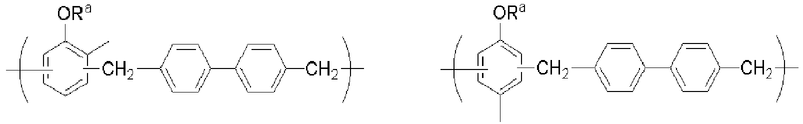

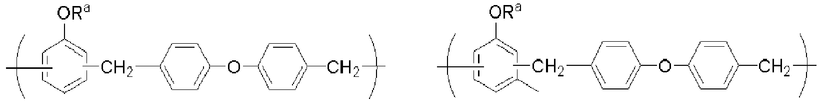

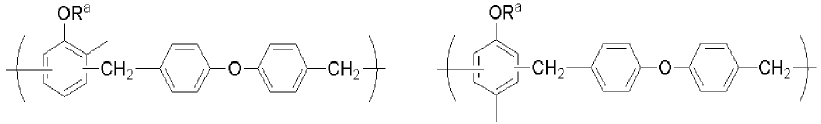

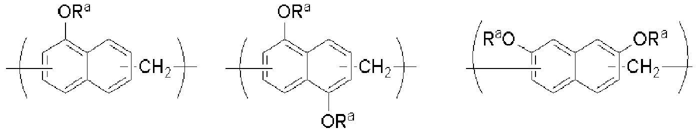

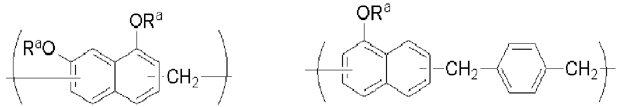

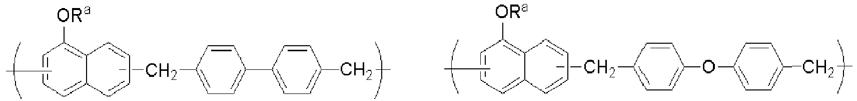

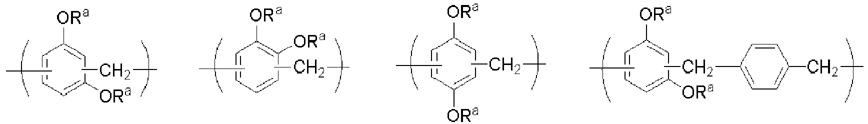

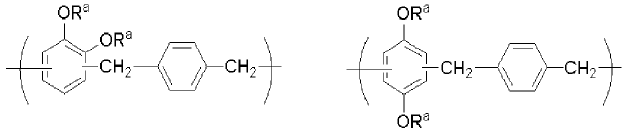

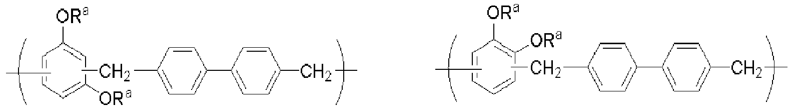

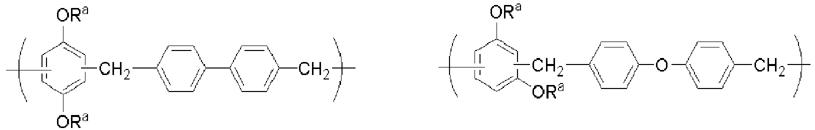

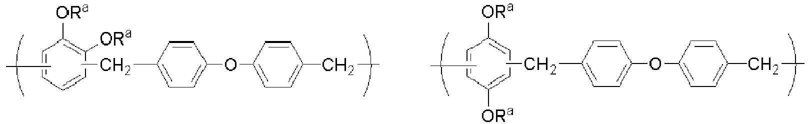

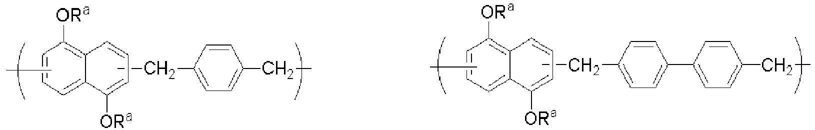

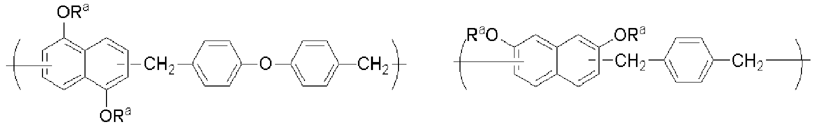

The ratio of the number of the hydroxyl groups to the number of the organic groups represented by the general formula (2) above contained in the above general formula (A-5) preferably satisfies a relationship e+f=1 and 0.1≤f≤0.9, more preferably 0.2≤f≤0.8, further preferably 0.3≤f≤0.7, wherein "e" represents the proportion of the hydroxyl group and "f" represents the proportion of the organic group represented by the above general formula (2).

By controlling the ratio between the hydroxyl group and the above general formula (2) within the above range, it is possible to achieve high thermal flowability and high substrate adhesiveness, thus providing a composition for forming a wafer edge protection film with excellent wafer edge coverage and excellent defect suppression property. In order to improve the adhesiveness of the film with respect to the substrate, the proportion "e" of the hydroxyl group may be increased, that is, e>f may be satisfied, and in order to improve the curability, the heat resistance, and the defect suppression property, e<f may be satisfied. These proportions can be arbitrarily adjusted according to the required performance.

The polymer containing the constituent unit represented by the above general formula (A-5) has a high carbon density because of its structure in which aromatic rings are linked via the organic group X. Accordingly, the composition for forming a wafer edge protection film containing these compounds exhibits high dry etching resistance and has excellent heat resistance, thereby forming a protection film with fewer sublimates. Further, since the organic group having the structure represented by the above general formula (2), which contributes to improvement in thermal flowability, is directly bonded to the aromatic ring, which is the scaffold structure of the resin, via an oxygen atom, the composition for forming a wafer edge protection film formed from these polymers can achieve both film forming property and thermal resistance/etching resistance at high levels. Further, since the aromatic ring structure as the scaffold is not excessively rigid and forms a repeating structure via the organic group (X), which serves as a linkage group, it is possible to form a thick protection film on a wafer edge without generating cracks or other defects. As described above, the composition for forming a wafer edge protection film formed from these polymers can achieve both film forming property and heat resistance/etching resistance at high levels, thus allowing formation of a thick film according to the required characteristics.

The composition for forming a wafer edge protection film of the present invention preferably contains 10 % by mass or more, more preferably 15 % by mass or more, further preferably 20 % by mass or more of the above resin (A) therein.

Even in dry etching processes for forming fine patterns with ultra-high aspect ratios on a substrate to be processed, it is necessary to form a thick wafer edge protection film to protect wafer edges from the etchant until etching of the substrate to be processed is completed. With the composition for forming a wafer edge protection film containing the above resin (A) in the above content, it is possible to form a thick wafer edge protection film according to the required characteristics.

### (B) Solvent

The solvent (organic solvent) that can be used for the composition for forming a wafer edge protection film described above is not particularly limited, and any solvents that can dissolve the resin (A) above may be used. The solvent is preferably capable of also dissolving crosslinking agent, surfactant, acid generator, and plasticizer, which are described later.

Specifically, solvents described in paragraphs [0091] to [0092] of Japanese Laid-Open Patent Application Publication No. 2007-199653 may be added. Further specifically, propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture of one or more kinds thereof are preferably used.

The addition amount of the organic solvent is preferably adjusted according to the set thickness of the wafer edge protection film; however, the addition amount is usually in the range of 100 to 50,000 parts by mass per 100 parts by mass of the above resin (A).

### (C) Crosslinking Agent

A cross-linking agent may also be added to the composition for forming a wafer edge protection film described above to improve curability and etching resistance. The crosslinking agent is not particularly limited, and various known crosslinking agents can be widely used. Examples thereof include a melamine-based crosslinking agent, a glycoluril-based crosslinking agent, a benzoguanamine-based crosslinking agent, a urea-based crosslinking agent, a β-hydroxyalkylamide-based crosslinking agent, an isocyanurate-based crosslinking agent, an aziridine-based crosslinking agent, an oxazoline-based crosslinking agent, an epoxy-based crosslinking agent, and a phenol-based crosslinking agent (e.g., a polynuclear phenol-based crosslinking agent such as a methylol or alkoxymethyl-based crosslinking agent). When the crosslinking agent is added, the addition amount is preferably 5 to 100 parts by mass, more preferably 10 to 50 parts by mass, per 100 parts by mass of the above resin (A).

Specific examples of the melamine-based crosslinking agent include hexamethoxymethylated melamine, hexabutoxymethylated melamine, alkoxy- and/or hydroxy-substituted derivatives thereof, and partial self-condensates thereof. Specific examples of the glycoluril-based crosslinking agent include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agent include tetramethoxymethylated benzoguanamine, tetrabutoxymethylated benzoguanamine, alkoxy- and/or hydroxy-substituted derivatives thereof, and partial self-condensates thereof. Specific examples of the urea crosslinking agent include dimethoxymethylated dimethoxyethyleneurea, alkoxy- and/or hydroxy-substituted derivatives thereof, and partial self-condensates thereof. Specific examples of the β-hydroxyalkylamide crosslinking agent include N,N,N',N'-tetra(2-hydroxyethyl)adipic acid amide. Specific examples of the isocyanurate-based crosslinking agent include triglycidyl isocyanurate and triallyl isocyanurate. Specific examples of the aziridine-based crosslinking agent include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agent include 2,2'-isopropylidene bis(4-benzyl-2-oxazoline), 2,2'-isopropylidene bis(4-phenyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer. Specific examples of the epoxy-based crosslinking agent include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agent include a compound represented by the following general formula (C-2), 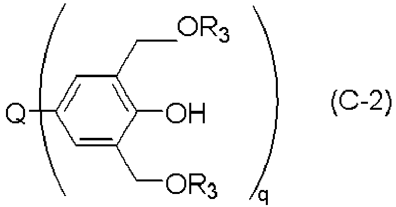 wherein Q is a single bond or a q-valent hydrocarbon group having 1 to 20 carbon atoms; R₃ is a hydrogen atom or a methyl group; and "q" is an integer of 1 to 5.

In the above general formula (C-2), Q is a single bond or an q-valent hydrocarbon group having 1 to 20 carbon atoms; and "q" is an integer of 1 to 5, more preferably 2 or 3. When Q is a q-valent hydrocarbon group having 1 to 20 carbon atoms, Q is a q-valent hydrocarbon group from which q hydrogens are removed from a hydrocarbon with 1 to 20 carbon atoms. More specific examples of the hydrocarbon having 1 to 20 carbon atoms in this case include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane.

In the above general formula (C-2), R₃ is a hydrogen atom or a methyl group, preferably a methyl group.

By having the compound represented by the above general formula (C-2) as a crosslinking agent, it is possible to increase the crosslinking reactivity of the hydroxyl groups contained in the above resin (A) and improve the denseness of the film. This enables further improvement in heat resistance characteristics of the composition for forming a wafer edge protection film.

Specific examples of the compound represented by the above general formula (C-2) include, but are not limited to, the following compounds. In the following formula, R₃ is as defined above. The condition satisfying "q" = 3 and R₃ = methyl group is preferred from the viewpoint of improvement in curability and film thickness uniformity, and reduction of sublimates. In particular, a hexamethoxymethylated derivative of triphenolmethane, triphenolethane, 1,1,1,-tris (4-hydroxyphenyl)ethane, and tris (4-hydroxyphenyl)-1-ethyl-4-isopropylbenzene are preferred.

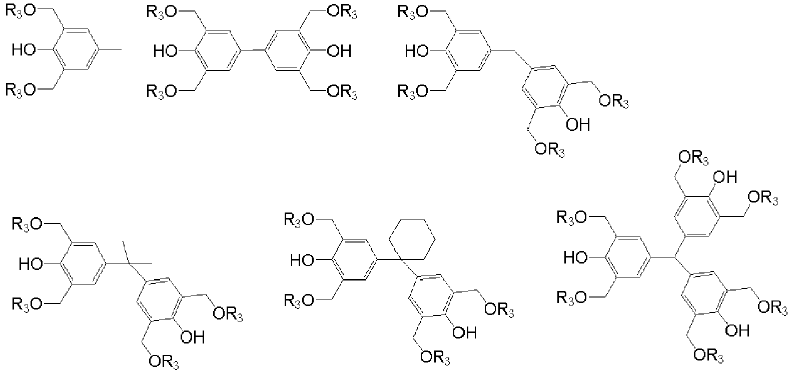

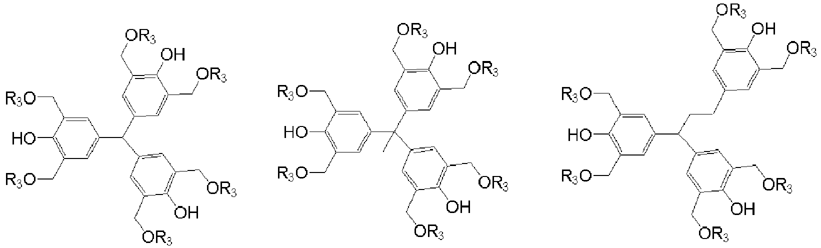

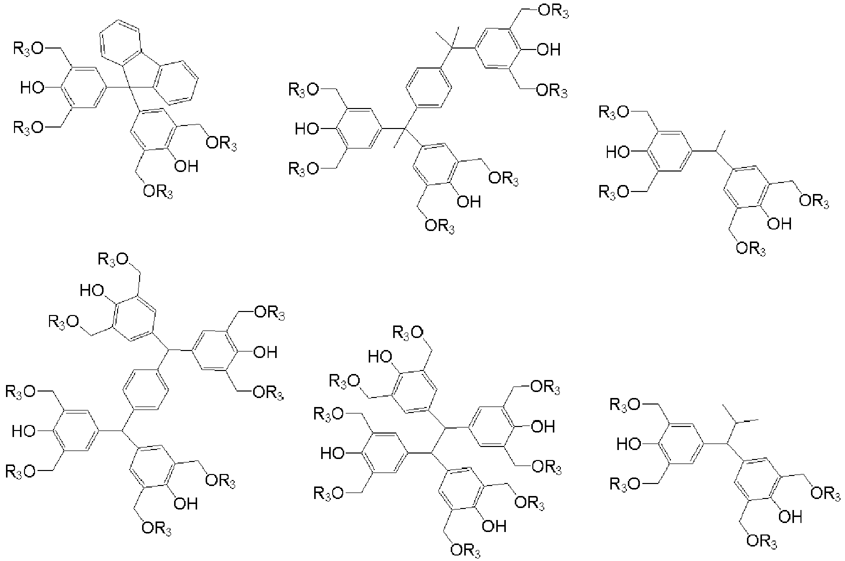

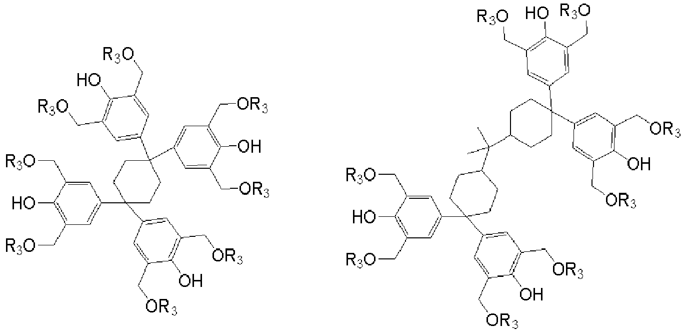

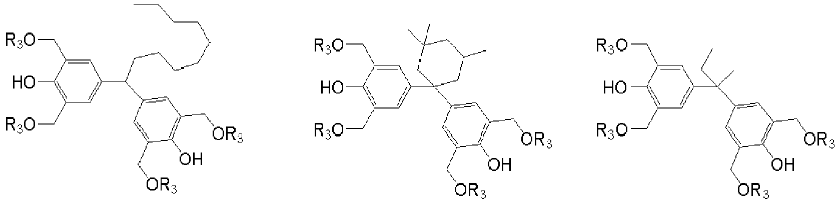

These crosslinking agents may be used individually or in a combination of two or more kinds. The content of the crosslinking agent is preferably 5 to 100% by mass, more preferably 10 to 50% by mass, per 100% by mass of the above resin (A). If the additive amount is 5 % by mass or more, the crosslinking reaction with the (A) resin is promoted and a dense film with excellent curability is formed, thus enabling formation of a wafer edge protection film having desirable heat resistance characteristics, dry etching resistance, and film thickness uniformity. On the other hand, if the additive amount is 100% by mass or less, generation of sublimates accompanying the slowing down of the crosslinking reaction between the (A) resin and the (C) crosslinking agent can be suppressed, and the generation of sublimates and degradation of film thickness uniformity can be reduced.

### (D) High Boiling Point Solvent

Further, apart from the (B) solvent, a high boiling point solvent may be added to the above composition for forming a wafer edge protection film. In this case, the organic solvent contained in the composition may be a mixture of one or more organic solvents having a boiling point of less than 180°C and one or more organic solvents having a boiling point of 180°C or higher (hereinafter referred to as "(D) high boiling point solvent").

Specific examples of the organic solvent having a boiling point of less than 180°C include propylene glycol monomethyl ether acetate, propylene glycol monomethyl ether, propylene glycol monoethyl ether, propylene glycol monopropyl ether, 2-heptanone, cyclopentanone, and cyclohexanone.

Examples of the (D) high boiling point solvent include, with no particular limitation, any of hydrocarbons, alcohols, ketones, esters, ethers, chlorine-based solvents and the like, insofar as it is capable of dissolving the components of the composition for forming a wafer edge protection film of the present invention. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate, and the like. They may be used alone or as a mixture.

The (D) high boiling point solvent may be appropriately selected, for example, from the above solvents, according to the temperature at which the above composition for forming a wafer edge protection film is subjected to the heat treatment, and the like. The boiling point of the (D) high boiling point solvent is preferably 180°C to 300°C, more preferably 200°C to 300°C. With such a boiling point, there is no risk of excessively rapid volatilization during baking (heat treatment) due to an excessively low boiling point. It is therefore assumed that sufficient thermal flowability can be obtained during the film formation, and a wafer edge protection film with excellent uniform coatability can be formed even at a wafer edge portion, which is difficult to coat. Further, the solvent having such a boiling point can prevent the risk of not being able to evaporate after baking due to the high boiling point and remaining in the film, and thus does not adversely affect physical properties of the film, such as etching resistance.

When the (D) high boiling point solvent is used, the addition amount thereof is preferably 1 to 200 parts by mass, more preferably 1 to 100 parts by mass, per 100 parts by mass of the above resin (A). With this range of addition amount, there is no risk of insufficient thermal flowability at baking due to an excessively small addition amount, and also there is no risk of degradation of physical properties of the film, such as etching resistance, due to an excessively large addition amount, which results in residual solvent in the film.

### (E) Surfactant

A (E) surfactant may be added to the composition for forming a wafer edge protection film described above in order to improve coatability in spin coating. Specific examples of the surfactant include those disclosed in paragraphs [0142] to [0147] of the Japanese Laid-Open Patent Application Publication No. 2009-269953. When the surfactant is added, the addition amount is preferably 0.001 to 20 parts by mass, more preferably 0.01 to 10 parts by mass, per 100 parts by mass of the above resin (A).

### (F) Acid Generator

An (F) acid generator may be added to the composition for forming a wafer edge protection film described above in order to further promote the curing reaction. The acid generator can be classified into those that generate an acid by thermal decomposition and those that generate an acid by optical irradiation; however, any acid generators can be added. Specific examples of the acid generator include, but not limited to, those disclosed in paragraphs [0061] to [0085] of Japanese Patent Laid-Open Publication No. 2007-199653.

These acid generators may be used individually or in a combination of two or more kinds. When the acid generator is added, the addition amount is preferably 0.05 to 50 parts by mass, more preferably 0.1 to 10 parts by mass, per 100 parts by mass of the above resin (A) .

### (G) Plasticizer

Further, a (G) plasticizer may be added to the composition for forming a wafer edge protection film described above to further improve the film forming property on the wafer edge. The plasticizer is not particularly limited, and various known plasticizers can be widely used. Examples of the plasticizer include low molecular weight compounds such as phthalate esters, adipate esters, phosphate esters, trimellitate esters, and citrate esters; polymers such as polyether-based polymers, polyester-based polymers, and polyacetal-based polymers disclosed in the Japanese Laid-Open Patent Application Publication No. 2013-253227, and the like. When the plasticizer is added, the addition amount is preferably 5 to 500 parts by mass, more preferably 10 to 200 parts by mass, per 100 parts by mass of the above resin (A).

Further, in addition to those components above, an additive may be added to the composition for forming a wafer edge protection film described above to further improve the film forming property on the wafer edge. The additive is not particularly limited, and any additives that contribute to improvement in thermal flowability and impart film forming property on wafer edge may be added. Preferable examples thereof include liquid additives having polyethylene glycol or polypropylene glycol structures and thermo-decomposable polymers having a weight loss ratio between 30°C and 250°C of 40% by mass or more and a weight average molecular weight of 300 to 200,000. The thermo-decomposable polymer preferably contains a repeating unit having an acetal structure represented by the following general formulae (DP1) and (DP1a). 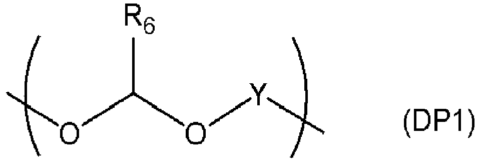 In the formula, R₆ represents a hydrogen atom or a saturated or unsaturated monovalent organic group having 1 to 30 carbon atoms which may be substituted; and Y represents a saturated or unsaturated divalent organic group having 2 to 30 carbon atoms. 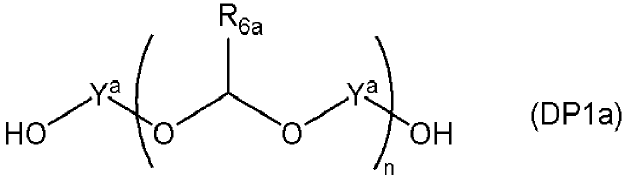 In the formula, R₆ₐ is an alkyl group having 1 to 4 carbon atoms; Y^{a} is a saturated or unsaturated divalent hydrocarbon group having 4 to 10 carbon atoms and optionally containing an ether bond; and n represents an average repeating unit number of 3 to 500.

### Patterning Process

The present invention also provides a patterning process for forming a protection film on a peripheral edge of a substrate to be processed on which a film with a pattern is formed and forming a pattern on the substrate to be processed, the patterning process comprising the steps of:
(I-1) applying a composition for forming a protection film comprising an aromatic ring-containing resin (A) having an organic group represented by the above general formula (1) and a solvent to a peripheral edge of a substrate to be processed on which a film with a pattern is formed;
(I-2) curing the applied composition for forming a protection film by a heat treatment or optical irradiation to form a protection film on a peripheral edge of the substrate;
(I-3) forming a pattern on the substrate to be processed by dry etching while using the film with a pattern as a mask; and
(I-4) removing the protection film.

An example of the patterning process of the present invention is specifically explained below using FIG. 6. First, in the step (I-1), a substrate to be processed 1 on which a film 7 with a pattern is formed is placed on a spin chuck (FIG. 6(O)), and the composition for forming a protection film 8 of the present invention described above is applied to the peripheral edge of the substrate to be processed 1 from a supply nozzle 3 (FIG. 6(P)). Next, in the step (I-2), the applied composition for forming a protection film 8 is cured by a heat treatment or optical irradiation to form a protection film 8A on the peripheral edge (FIG. 6(Q)). Next, in the step (I-3), a pattern 1A is formed on the substrate to be processed 1 by dry etching while using the film 7 with a pattern as a mask (FIG. 6(R)). Then, in the step (I-4), the film 7 with a pattern is removed (FIG. 6(S)), followed by removal of the protection film 8A (FIG. 6(T)).

If the wafer edge is damaged by dry etching, particles generated from the wafer edge may scatter toward the center of the wafer, thus causing pattern bridging or disconnection. In contrast, in the above patterning process of the present invention, the peripheral edge on the surface side and the peripheral edge on the backside of the substrate to be processed are protected by wafer edge protection films; therefore, it is possible to prevent generation of defects from the wafer edge during the dry etching process, thereby enabling formation of patterns on the substrate to be processed with high accuracy and less defects.

The film with a pattern formed on the substrate to be processed is not particularly limited. Examples thereof include resist upper layer film, silicon-containing resist middle layer film, inorganic hard mask middle layer film, resist underlayer film, and the like. Since the film with a pattern is used as a mask to process the substrate to be processed, particle generation from the wafer edge can be prevented if the protection film can be formed on the wafer edge using the composition for forming a wafer edge protection film before dry etching is started. Therefore, the film with a pattern is preferably a resist upper layer film.

The patterning process of the present invention is suitable for a multilayer resist processes, such as a silicon-containing two-layer resist process, a three-layer resist process using a resist underlayer film and a silicon-containing resist middle layer film, a four-layer resist process using a resist underlayer film, an inorganic hard mask middle layer film, and an organic thin film, a silicon-free two-layer resist process, and the like. Therefore, a silicon-containing resist middle layer film, an inorganic hard mask middle layer film, an organic thin film, a resist underlayer film, and the like may be formed between the resist upper layer film in which a pattern is formed and the substrate to be processed, and a resist underlayer film or the like may be formed between the silicon-containing resist middle layer film or the inorganic hard mask middle layer film in which a pattern is formed and the substrate to be processed.

When the resist underlayer film is formed, the resist underlayer film can be formed by a method using a coating-type organic underlayer film composition, a CVD method, an ALD method, or the like. Examples of the coating-type organic underlayer film composition include resins and compositions disclosed in Japanese Patent Laid-Open Publication No. JP2012-1687, Japanese Patent Laid-Open Publication No. JP2012-77295, Japanese Patent Laid-Open Publication No. JP2004-264710, Japanese Patent Laid-Open Publication No. JP2005-043471, Japanese Patent Laid-Open Publication No. JP2005-250434, Japanese Patent Laid-Open Publication No. JP2007-293294, Japanese Patent Laid-Open Publication No. JP2008-65303, Japanese Patent Laid-Open Publication No. JP2004-205685, Japanese Patent Laid-Open Publication No. JP2007-171895, Japanese Patent Laid-Open Publication No. JP2009-14816, Japanese Patent Laid-Open Publication No. JP2007-199653, Japanese Patent Laid-Open Publication No. JP2008-274250, Japanese Patent Laid-Open Publication No. JP2010-122656, Japanese Patent Laid-Open Publication No. JP2012-214720, Japanese Patent Laid-Open Publication No. JP2014-29435, International Publication No. WO2012/077640, International Publication No. WO2010/147155, International Publication No. WO2012/176767, Japanese Patent Laid-Open Publication No. JP2005-128509, Japanese Patent Laid-Open Publication No. JP2006-259249, Japanese Patent Laid-Open Publication No. JP2006-259482, Japanese Patent Laid-Open Publication No. JP2006-293298, Japanese Patent Laid-Open Publication No. JP2007-316282, Japanese Patent Laid-Open Publication No. JP2012-145897, Japanese Patent Laid-Open Publication No. JP2017-119671, Japanese Patent Laid-Open Publication No. JP2019-44022, and the like. Further, a resist underlayer film composition containing metal atoms such as Sn, In, Ga, Ge, Al, Ce, La, Cs, Zr, Hf, Ti, Bi, Sb, Zn, and the like may also be used.

When the inorganic hard mask middle layer film is formed, a silicon oxide film, a silicon nitride film, and a silicon oxynitride film (SiON film) are formed by a CVD method, an ALD method, or the like. The method for forming a nitride film is disclosed in Japanese Laid-Open Patent Application Publication No. 2002-334869 and International Publication No. WO2004/066377. The thickness of the inorganic hard mask middle layer film is 5 to 3,000 nm, preferably 10 to 2,000 nm. Among them, SiON films having a high function as an antireflective film are most preferably used for ArF exposure.

As the silicon-containing resist middle layer film, a polysilsesquioxane-based resist middle layer film is preferably used. The polysilsesquioxane-based resist middle layer film can be easily imparted an anti-reflective effect in excimer exposure, whereby the reflection can be suppressed in pattern exposure of the resist upper layer film, and thus excellent resolution can be obtained. In particular, when a composition containing many aromatic groups is used as the resist underlayer film for 193-nm exposure, a k-value increases and thus substrate reflection also increases. However, the resist middle layer film can reduce the reflection, thereby enabling the substrate reflection to decrease to 0.5% or less. As the resist middle layer film having an anti-reflective effect, a polysilsesquioxane which has a pendant anthracene for exposure of 248 nm or 157 nm, or a pendant phenyl group or a pendant light-absorbing group having a silicon-silicon bond for 193 nm exposure, and which is crosslinkable by acid or heat, is preferably used.

In the patterning process described above, the resist upper layer film may be of a positive type or a negative type, and any common photoresist composition may be used. Further, the photoresist composition may contain metal atoms such as Sn, In, Ga, Ge, Al, Ce, La, Cs, Zr, Hf, Ti, Bi, Sb, Zn, and the like. When a resist upper layer film is formed using the above photoresist composition, the formation can be performed by spin coating or by vapor deposition process using CVD or ALD.

When the photoresist composition is formed by spin coating, prebaking is conducted after the application of the resist, and the prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

When a photoresist composition is formed by a vapor deposition process using CVD or ALD, the above resist composition is an EUV-sensitive metal oxide film, and the above metal is selected from Sn, Zr, Hf, Ti, Bi, Sb, and the like, preferably Sn, which has excellent EUV sensitivity. The metal oxide-containing film may be a photosensitive organometallic oxide film, such as an organotin oxide (e.g., haloalkyl Sn, alkoxyalkyl Sn, or amidoalkyl Sn), and the like. Some specific examples of suitable precursors include trimethyltin chloride, dimethyltin dichloride, methyltin trichloride, tris(dimethylamino)methyltin(IV), and (dimethylamino)trimethyltin(IV) .

The metal oxide film may be deposited by PECVD or PEALD, for example, using a Lam Vector (registered trademark) tool. In the ALD example, the Sn oxide precursor is separated from O precursor/plasma. The deposition temperature is preferably in the range of 50°C to 600°C. The deposition pressure is preferably between 100 and 6000 mTorr. The flow rate of the precursor solution of the metal oxide-containing film (e.g., organotin oxide precursor) may be 0.01 to 10 cmm, and the gas flow rate (CO₂, CO, Ar, N₂) may be 100 to 10,000 sccm. The plasma power provided from high frequency plasma (e.g., 13.56 MHz, 27.1 MHz, or higher frequency) may be 200-1000 W per 300 mm wafer station.
The deposition thickness is preferably 100 to 2000 Å.

Examples of light for exposure include high energy beams at wavelengths of 300 nm or less, specifically excimer lasers at 248 nm, 193 nm, and 157 nm, soft X-rays at 3 to 20 nm, an electron beam, X-rays, and the like.

As the method for removing the wafer edge protection film from the wafer edge of the substrate to be processed after the patterning process on the substrate to be processed, removal by dry etching is preferable. When the wafer edge protection film is removed by dry etching, the wafer edge protection film can be removed by etching using oxygen-based or hydrogen-based gases because the wafer edge protection film is constituted of an organic film.

For example, if the substrate is Si, SiO₂, SiN, SiON, or silica-based low dielectric constant insulating film, which is resistant to etching using oxygen-based or hydrogen-based gas, the wafer edge protection film can be removed without damaging the wafer edge of the substrate to be processed.

If the wafer edge is damaged by dry etching, particles generated from the wafer edge may scatter toward the center of the wafer, thus causing pattern bridging or disconnection. In contrast, in the above patterning process of the present invention, the peripheral edge on the surface side and the peripheral edge on the backside of the substrate to be processed are protected by wafer edge protection films; therefore, it is possible to prevent generation of defects from the wafer edge during the dry etching process, thereby enabling formation of patterns on the substrate to be processed with high accuracy and less defects. It is also possible to suppress the risk of adherence of particles generated by etching of a film containing metal atoms to the wafer edge, which causes metallic contamination of the wafer edge.

In addition, the present invention also provides a patterning process for forming a protection film on a peripheral edge of a substrate to be processed and forming a pattern on the substrate to be processed, the patterning process comprising the steps of:
(II-1) applying a composition for forming a protection film comprising an aromatic ring-containing resin (A) having an organic group represented by the above general formula (1) and a solvent to a peripheral edge of a substrate to be processed;
(II-2) curing the applied composition for forming a protection film by a heat treatment or optical irradiation to form a protection film on a peripheral edge of the substrate to be processed;
(II-3) forming a resist upper layer film pattern on the substrate to be processed and forming a pattern on the substrate to be processed by dry etching while using the resist upper layer film pattern as a mask; and
(II-4) removing the protection film.

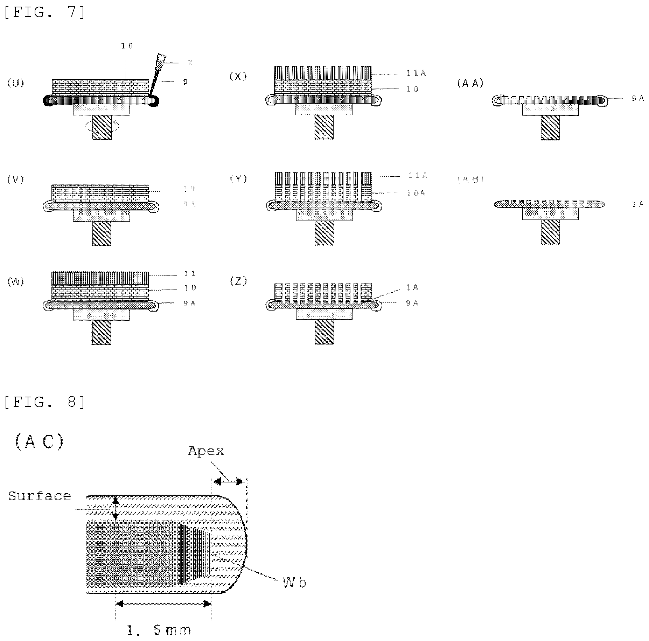

An example of the patterning process of the present invention is specifically explained below using FIG. 7. First, in the step (II-1), the composition for forming a protection film 9 of the present invention described above is applied to a peripheral edge of a substrate to be processed placed on a spin chuck from the supply nozzle 3. The substrate to be processed may have a layer to be processed 10 formed thereon, such as a silicon-containing resist middle layer film, an inorganic hard mask middle layer film, an organic thin film, a resist underlayer film, and the like (FIG. 7(U)). Next, in the step (II-2), the applied composition for forming a protection film 9 is cured by a heat treatment or optical irradiation to form a protection film 9A on the peripheral edge (FIG. 7(V)). Next, in the step (II-3), a resist upper layer film 11 is formed on the layer to be processed 10 (FIG. 7(W)), followed by exposure to light, thereby forming a resist upper layer film pattern 11A (FIG. 7(X)). Then, the pattern 11A is used as a mask to form a pattern 10A in the layer to be processed 10 by dry etching (FIG. 7(Y)), and the pattern 10A is further used as a mask to form a pattern 1A on the substrate to be processed by dry etching (FIG. 7(Z)). Then, in the step (II-4), the layer to be processed 10 with the pattern 10A is removed (FIG. 7(AA)), followed by removal of the protection film 9A (FIG. 7(AB)).

With the above patterning process, it is possible to suppress particle generation from the wafer edge when the substrate to be processed is dry-etched. Further, it is possible to prevent such a risk that the chemical liquid supplied to the surface of the substrate may run into the peripheral portion on the backside during the formation of a resist upper layer film, thus forming a coating film also on the peripheral portion on the backside for which formation of a coating film is not intended, resulting in contamination in these areas.

When a resist upper layer film is formed using the above photoresist composition, the formation is preferably performed by spin coating. When the photoresist composition is formed by spin coating, prebaking is conducted after the application of the resist, and the prebaking is preferably performed at 60 to 180°C for 10 to 300 seconds. Thereafter, exposure is conducted according to a usual manner, followed by post-exposure baking (PEB) and development, thereby obtaining a resist upper layer film pattern. Although the thickness of the resist upper layer film is not particularly limited, the thickness is preferably 10 to 500 nm, particularly preferably 20 to 400 nm.

In the patterning process described above, the resist upper layer film may be of a positive type or a negative type, and any common photoresist composition and metal atom-containing photoresist composition may be used.

When the above resist upper layer film used in the above patterning process is a composition containing a metal atom, the above patterning process using the composition for forming a wafer edge protection film of the present invention is particularly effective in terms of inhibiting contamination of the wafer edges on the surface side and the backside. Therefore, the above resist upper layer film is preferably formed from a composition containing a metal atom.

When the above photoresist composition contains a metal atom, the metal atom is preferably Sn, In, Ga, Ge, Al, Ce, La, Cs, Zr, Hf, Ti, Bi, Sb and Zn, and particularly preferably Sn, Zr, Hf and Ti.

Examples of light for exposure include high energy beams at wavelengths of 300 nm or less, specifically excimer lasers at 248 nm, 193 nm, and 157 nm, soft X-rays at 3 to 20 nm, an electron beam, X-rays, and the like. Among these, extreme ultraviolet having a wavelength of 3 to 15 nm is preferable.

In the above patterning process, a silicon-containing resist middle layer film, an inorganic hard mask middle layer film, an organic thin film, a resist underlayer film, and the like may be formed between the substrate to be processed and the resist upper layer film.

The above patterning process may be a process of applying the composition for forming a wafer edge protection film of the present invention to a substrate to be processed, a substrate in which a resist underlayer film is formed on a substrate to be processed, a substrate in which a resist underlayer film and a silicon-containing resist middle layer film or an inorganic hard mask are formed on a substrate to be processed, a substrate in which a resist underlayer film, an inorganic hard mask and an organic thin film are formed on a substrate to be processed, and a substrate in which a silicon-containing resist middle layer film or an inorganic hard mask is formed on a substrate to be processed, to form a wafer edge protection film, and then applying a resist upper layer film.

The patterning process of the present invention is suitable for a multilayer resist processes, such as a silicon-containing two-layer resist process, a three-layer resist process using a resist underlayer film and a silicon-containing resist middle layer film, a four-layer resist process using a resist underlayer film, an inorganic hard mask middle layer film, and an organic thin film, a silicon-free two-layer resist process, and the like.

As the method for removing the wafer edge protection film of the present invention from the wafer edge of the substrate to be processed after the patterning process on the substrate to be processed, removal by dry etching is preferable. When the wafer edge protection film is removed by dry etching, the wafer edge protection film can be removed by etching using oxygen-based or hydrogen-based gases because the wafer edge protection film is constituted of an organic film.

For example, if the substrate is Si, SiO₂, SiN, SiON, or silica-based low dielectric constant insulating film, which is resistant to etching using oxygen-based or hydrogen-based gas, the wafer edge protection film can be removed without damaging the wafer edge of the substrate to be processed.

If the wafer edge is damaged by dry etching, particles generated from the wafer edge may scatter toward the center of the wafer, thus causing pattern bridging or disconnection. In contrast, in the above patterning process of the present invention, the peripheral edge on the surface side and the peripheral edge on the backside of the substrate to be processed are protected by wafer edge protection films having excellent dry etching resistance; therefore, it is possible to prevent generation of defects from the wafer edge during the dry etching process, thereby enabling formation of patterns on the substrate to be processed with high accuracy and less defects. Moreover, when the above resist upper layer film used in the above patterning process is a composition containing a metal atom, the above patterning process using the composition for forming a wafer edge protection film of the present invention is particularly effective in terms of inhibiting contamination of the wafer edges on the surface side and the backside.

### EXAMPLE

Hereinbelow, the present invention is specifically explained by showing Examples and Comparative Examples; however, the present invention is not limited by these descriptions. The molecular weight and the dispersity were measured by the following method. The weight average molecular weight (Mw) on polystyrene basis was measured by gel permeation chromatography (GPC) using tetrahydrofuran as an eluent, and the dispersity (Mw/Mn) was calculated.

### Synthesis Examples

In the following Synthesis Examples, the following compound group G: (G1) to (G8) and modifying agent group H: (H1) to (H6) were used.

The compound group G: (G1) to (G8) are shown below.

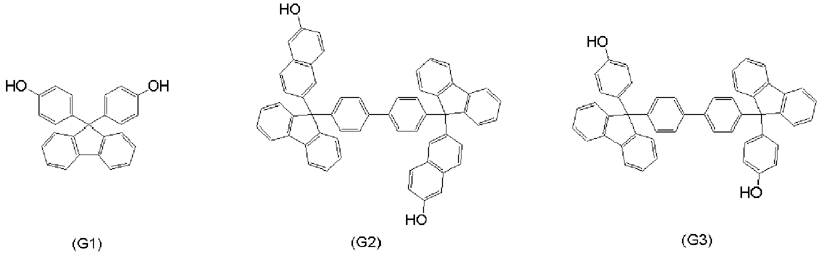

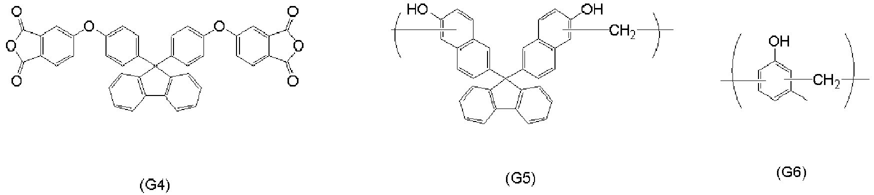

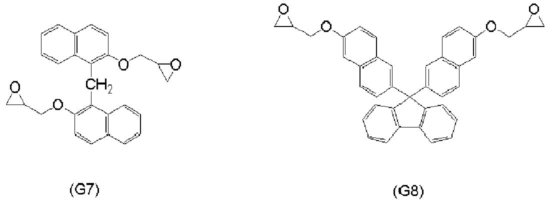

The modifying agent group H: (H1) to (H6) are shown below.

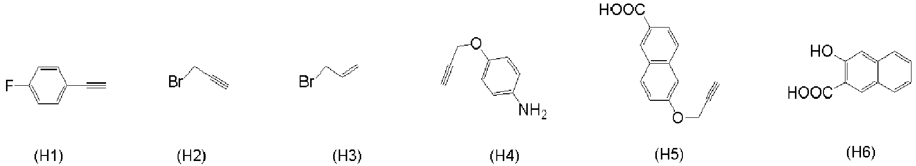

### Synthesis Example 1: Synthesis of Compound (B-1)

In an atmosphere of nitrogen, 200 g of N-methylpyrrolidone was added to 20.0 g of the compound (G1) in the starting material group, 16.4 g of the modifying agent (H1), and 23.3 g of potassium carbonate, followed by a reaction at an internal temperature of 140°C for 24 hours. After cooling at room temperature, 300 ml of methylisobutylketone and 300 ml of pure water were added to the reaction solution for homogenization; thereafter, the separated water layer was removed. Further, the organic layer was washed with 100 ml of a 3% aqueous nitric acid solution twice and washed with 100 ml of pure water five times, and then the organic layer was dried under reduced pressure to hardness. 100 g of THF was added to the residue to yield a homogeneous solution, and a crystal was precipitated by 350 g of methanol. The precipitated crystal was separated by filtration, washed twice with 200 g of methanol, and recovered. The recovered crystal was vacuum-dried at 70°C, thereby obtaining a compound (B-1) for a flowability accelerator.

The weight average molecular weight (Mw) and the dispersity (Mw/Mn) were determined by GPC, and the following results were obtained.
(B-1): Mw = 580, Mw/Mn = 1.03

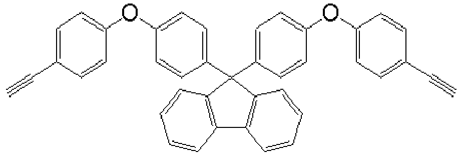

### Synthesis Example 2: Synthesis of Compound (B-2)

In an atmosphere of nitrogen, 45.5 g of the compound (G2) in the starting material group, 9.8 g of potassium carbonate, and 150 g of DMF were added, and a homogeneous dispersion liquid was prepared at an internal temperature of 50°C. 17.6 g of the modifying agent (H2) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a compound (B-2) for a flowability accelerator.

The weight average molecular weight (Mw) and the dispersity (Mw/Mn) were determined by GPC, and the following results were obtained.
(B-2): Mw = 965, Mw/Mn = 1.08

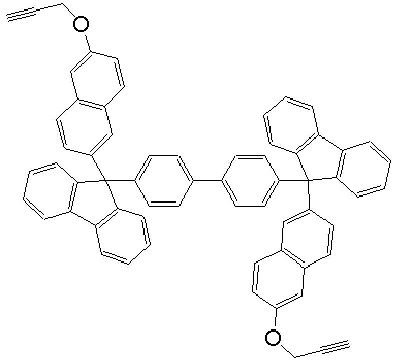

### Synthesis Example 3: Synthesis of Compound (B-3)

In an atmosphere of nitrogen, 46.9 g of the compound (G2), 10.1 g of potassium carbonate, and 150 g of DMF were added, and a homogeneous dispersion liquid was prepared at an internal temperature of 50°C. 9.0 g of the modifying agent (H2) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a compound (B-3) for a flowability accelerator.

The weight average molecular weight (Mw) and the dispersity (Mw/Mn) were determined by GPC, and the following results were obtained.
(B-3): Mw = 903, Mw/Mn = 1.08

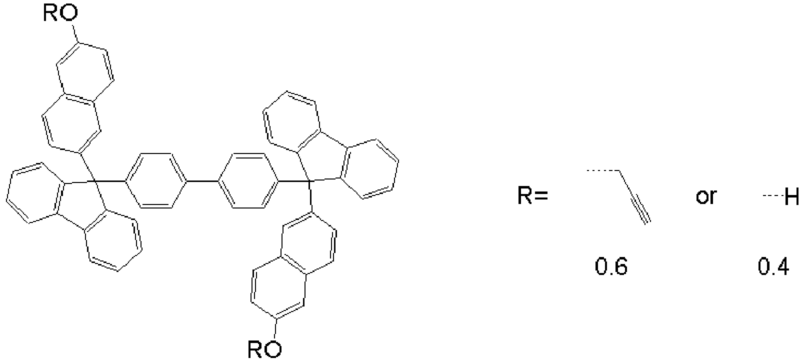

### Synthesis Example 4: Synthesis of Compound (B-4)

In an atmosphere of nitrogen, 47.2 g of the compound (G3), 11.7 g of potassium carbonate, and 150 g of DMF were added, and a homogeneous dispersion liquid was prepared at an internal temperature of 50°C. 8.6 g of the modifying agent (H3) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a compound (B-4) for a flowability accelerator.

The weight average molecular weight (Mw) and the dispersity (Mw/Mn) were determined by GPC, and the following results were obtained.
(B-4): Mw = 724, Mw/Mn = 1.01

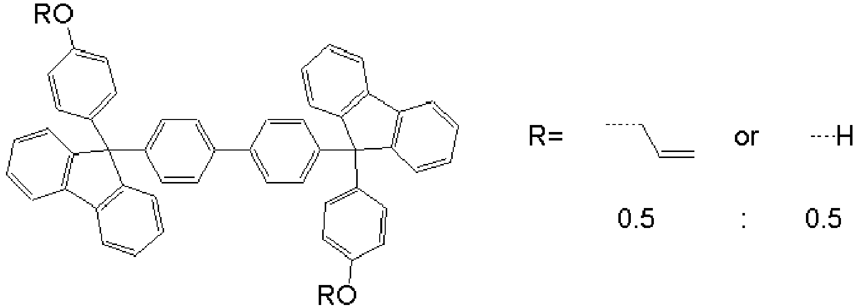

### Synthesis Example 5: Synthesis of Compound (B-5)

In an atmosphere of nitrogen, 100 g of N-methylpyrrolidone was added to 30.00 g of the compound (G4) in the starting material group, and a homogeneous solution was obtained at an internal temperature of 40°C in an atmosphere of nitrogen; thereafter, 13.7 g of the modifying agent (H4) was added, followed by a reaction at an internal temperature of 40°C for 3 hours, thereby obtaining an amide acid solution. 200 g of o-xylene was added to the obtained amide acid solution, and the mixture was reacted at an internal temperature of 150°C for 9 hours while removing the produced low-boiling substance and water from the system, thereby performing dehydrating imidation. The mixture was cooled to room temperature after the reaction and a crystal was precipitated by 1,000 g of methanol. The precipitated crystal was separated by filtration, washed twice with 500 g of methanol, and recovered. The recovered crystal was vacuum-dried at 70°C, thereby obtaining a compound (B-5) for a flowability accelerator.

The weight average molecular weight (Mw) and the dispersity (Mw/Mn) were determined by GPC, and the following results were obtained.
(B-5): Mw = 930, Mw/Mn = 1.01

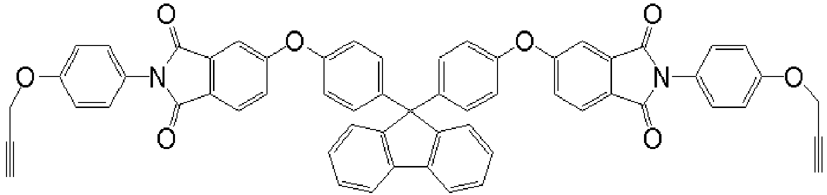

### Synthesis Example 6: Synthesis of Polymer (B-6)

In an atmosphere of nitrogen, 44.7 g of the compound (G5) in the starting material group, 16.5 g of potassium carbonate, and 150 g of DMF were added, and a homogeneous dispersion liquid was prepared at an internal temperature of 50°C. 16.5 g of the modifying agent (H2) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a polymer (B-6) for a flowability accelerator.

The weight average molecular weight (Mw) and the dispersity (Mw/Mn) were determined by GPC, and the following results were obtained.
(B-6): Mw = 2500, Mw/Mn = 3.10

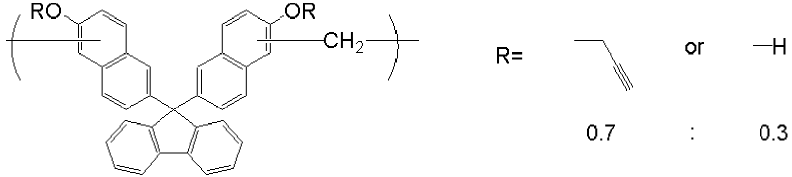

### Synthesis Example 7: Synthesis of Polymer (B-7)

In an atmosphere of nitrogen, 20.0 g of the resin (G6), 34.5 g of potassium carbonate, and 100 g of DMF were added, and a homogeneous dispersion liquid was prepared at an internal temperature of 50°C. 23.8 g of the modifying agent (H2) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a polymer (B-7) for a flowability accelerator.

The weight average molecular weight (Mw) and the dispersity (Mw/Mn) were determined by GPC, and the following results were obtained.
(B-7): Mw = 9,400, Mw/Mn = 3.59

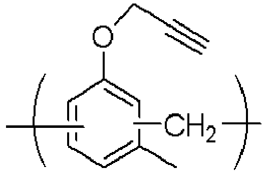

### Synthesis Example 8: Synthesis of Polymer (B-8)

In an atmosphere of nitrogen, 20.0 g of the resin (G6), 27.6 g of potassium carbonate, and 100 g of DMF were added, and a homogeneous dispersion liquid was prepared at an internal temperature of 50°C. 15.8 g of the modifying agent (H2) was slowly added, followed by a reaction at an internal temperature of 50°C for 24 hours. 300 ml of methylisobutylketone and 300 g of pure water were added to the reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a polymer (B-8) for a flowability accelerator.

The weight average molecular weight (Mw) and the dispersity (Mw/Mn) were determined by GPC, and the following results were obtained.
(B-8): Mw = 9,200, Mw/Mn = 3.53

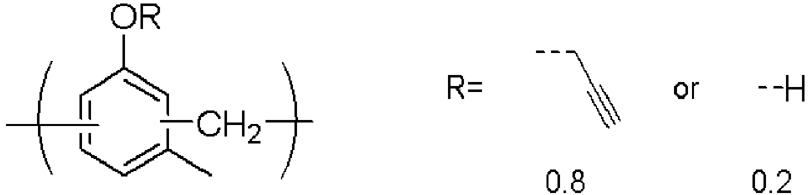

### Synthesis Example 9: Synthesis of Compound (B-9)

In an atmosphere of nitrogen, 51.0 g of the epoxy compound (G7), 56.6 g of the modifying agent (H5), and 600 g of 2-methoxy-1-propanol were mixed to yield a homogeneous solution at an internal temperature of 100°C, and then 5.7 g of benzyltriethylammonium chloride was added thereto, followed by stirring at an internal temperature of 120°C for 12 hours. After cooling to room temperature, 1,500 g of methylisobutylketone was added and the organic layer was washed with 300 g of pure water five times. The organic layer was dried under reduced pressure to hardness to obtain a compound (B-9) for a flowability accelerator.

The weight average molecular weight (Mw) and the dispersity (Mw/Mn) were determined by GPC, and the following results were obtained.
(B-9): Mw = 900, Mw/Mn = 1.04

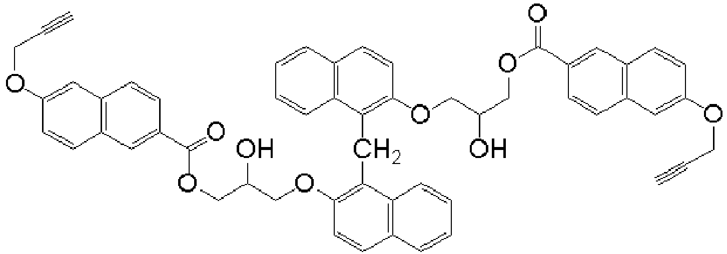

### Comparative Synthesis Example 1: Synthesis of Comparative Compound (R-2)

In an atmosphere of nitrogen, 77.5 g of the compound (G8) in the starting material group, 47.0 g of the modifying agent (H6), and 600 g of 2-methoxy-1-propanol were mixed to yield a homogeneous solution at an internal temperature of 100°C, and then 5.7 g of benzyltriethylammonium chloride was added thereto, followed by stirring at an internal temperature of 120°C for 12 hours. After cooling to room temperature, 1,500 g of methylisobutylketone was added and the organic layer was washed with 300 g of pure water five times. The organic layer was solidified under reduced pressure, thereby obtaining the compound (R-2).

The weight average molecular weight (Mw) and the dispersity (Mw/Mn) were determined by GPC, and the following results were obtained.
(R-2): Mw = 960, Mw/Mn = 1.03

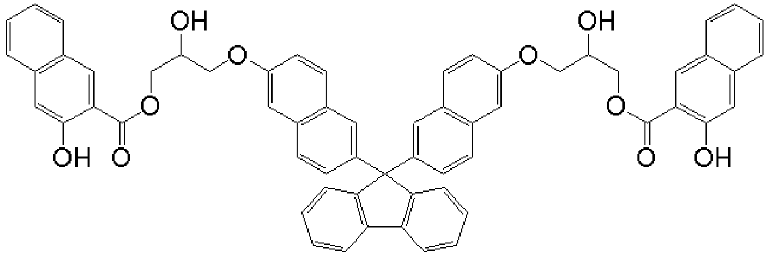

### Comparative Synthesis Example 2: Synthesis of Comparative Polymer (R-4)

In an atmosphere of nitrogen, 60.0 g of 2-vinylnaphthalene, 40.0 g of vinylbenzyl alcohol, 300 g of methyl ethyl ketone, and 5.0 g of dimethyl 2,2-azobis(isobutyrate) were added, and a reaction was performed for 8 hours at an internal temperature of 80°C. The mixture was cooled to room temperature after the reaction and a crystal was precipitated by 3,000 g of heptane. The precipitated crystal was separated by filtration, washed twice with 500 g of heptane, and recovered. The recovered crystal was vacuum-dried at 70°C, thereby obtaining the polymer (R-4).

The weight average molecular weight (Mw) and the dispersity (Mw/Mn) were determined by GPC, and the following results were obtained.
(R-4): Mw = 4,500, Mw/Mn = 2.0

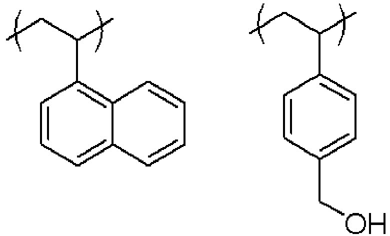

### Comparative Synthesis Example 3: Synthesis of Comparative Polymer (R-5)

17.8 g of 4-hydroxyphenyl methacrylate and 50 g of tetrahydrofuran as a solvent were added to a 2L flask. The reactor was cooled to -70°C in an atmosphere of nitrogen, degassed under reduced pressure, and a nitrogen gas was blown three times. The reactor was warmed to room temperature, and 1.2 g of AIBN (azobisisobutyronitrile) as a polymerization initiator was added thereto, followed by heating to 60°C, and a reaction was performed for 15 hours. The resulting reaction solution was added to a 1L isopropyl alcohol solution for precipitation. The resulting white solid was filtered and dried under reduced pressure at 60°C to obtain a white polymer (R-5).

The weight average molecular weight (Mw) and the dispersity (Mw/Mn) were determined by GPC, and the following results were obtained.
(R-5): Mw = 11,000, Mw/Mn = 2.11

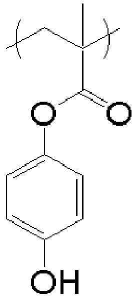

Tables 1 to 2 show the structures of the compounds and polymers used for the resulting composition for forming a wafer edge protection film, as well as their weight average molecular weights (Mw) and the dispersities (Mw/Mn). The compound (G5) in the starting material group G used as the starting material in Synthesis Examples was used for the comparative polymer (R-1), and the compound (G6) in the starting material group G was used for the comparative polymer (R-3).

**Table 1**

| Synthesis Examples | Compound or Polymer | Mw | Mw/Mn |
|---|---|---|---|
| 1 | 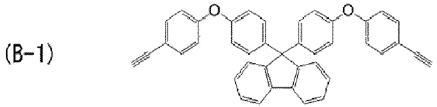 | 580 | 1.03 |
| 2 | 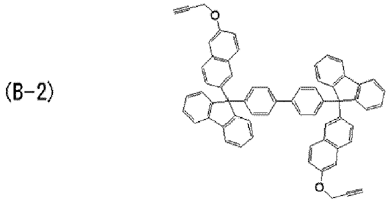 | 965 | 1.08 |
| 3 | 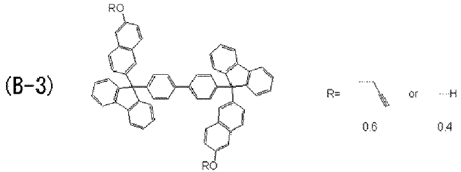 | 903 | 1.08 |
| 4 | 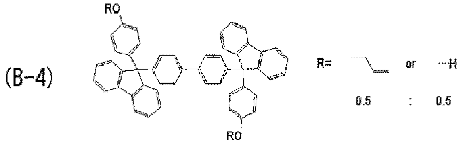 | 724 | 1.01 |
| 5 | 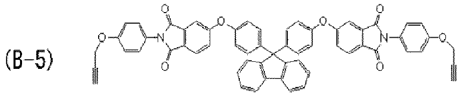 | 930 | 1.01 |
| 6 | 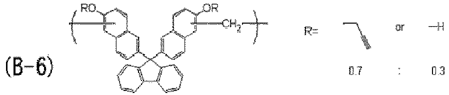 | 2500 | 3.10 |
| 7 | 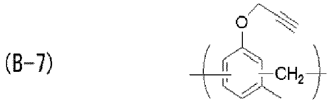 | 9400 | 3.59 |
| 8 | 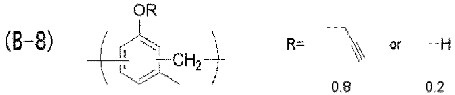 | 9200 | 3.53 |
| 9 | 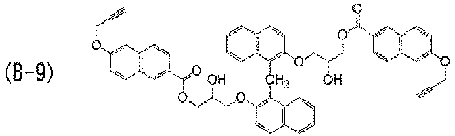 | 900 | 1.04 |

**Table 2**

| Comparative Synthesis Examples | Compound or Polymer | Mw | Mw/Mn |
|---|---|---|---|
| - | 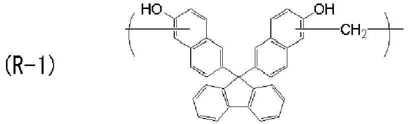 | 3700 | 2.82 |
| 1 | 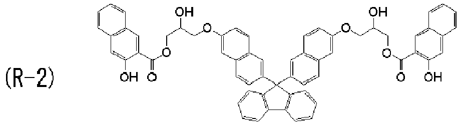 | 960 | 1.03 |
| - | 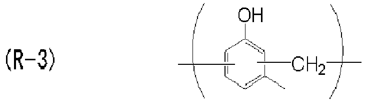 | 7000 | 7.50 |
| 2 | 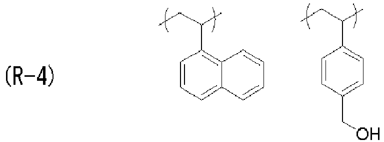 | 4500 | 2.00 |
| 3 | 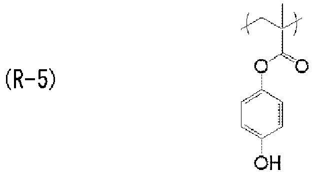 | 11000 | 2.11 |

### (C) Crosslinking Agent

Each of the (C) cross linking agents used for the composition for forming a wafer edge protection film is shown below.

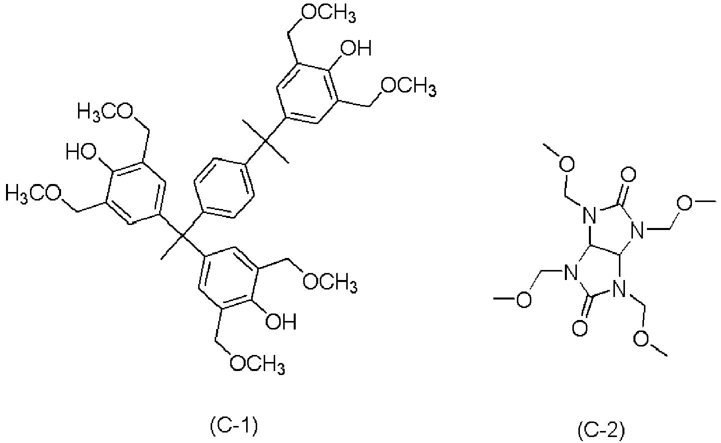

### (D) High Boiling Point Solvent

The (D) high boiling point solvent (Diethylene Glycol Monobenzyl Ether: boiling point 302°C) used for the composition for forming a wafer edge protection film is shown below.

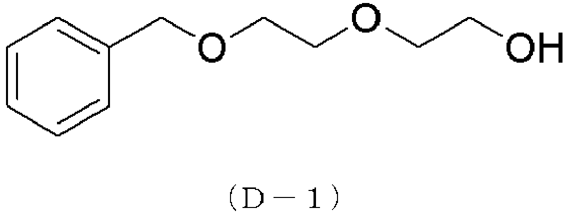

### (F) Thermal Acid Generator

The (F) thermal acid generator used for the composition for forming a wafer edge protection film is shown below.

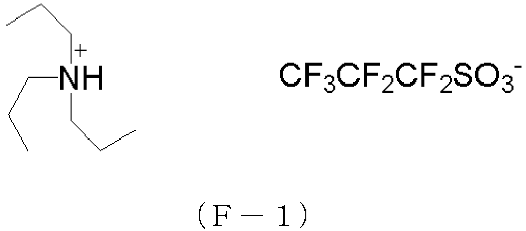

### Composition for Forming Wafer Edge Protection Film EPF-1

As the resin (A), the compound (B-1) for a flowability accelerator was dissolved at a proportion shown in Table 3 in propylene glycol monomethylether acetate (PGMEA) containing 0.5% by mass of a surfactant FC-4430 (manufactured by Sumitomo 3M Limited), and the solution was filtered through a 0.02 um membrane filter to prepare a composition for forming a wafer edge protection film (EPF-1).

### Compositions for Forming Wafer Edge Protection Film EPF-2 to 12, Comparative Examples EPF-1 to 5

Each chemical liquid was prepared in the same manner as that for EPF-1, except that the type and the content of each component were as shown in Table 3. In Table 3, "-" indicates that the component was not used.

**Table 3**

| Composition for Forming Edge Protection Film | (A) Resin (A) (part by mass) | (C) Crosslinking Agent (part by mass) | (F) Acid Generator (part by mass) | (D) High Boiling Point Solvent (part by mass) | (B) Solvent (part by mass) |
|---|---|---|---|---|---|
| EPF-1 | B-1 (100) | - | - | - | PGMEA (300) |
| EPF-2 | B-2 (100) | - | - | - | PGMEA (300) |
| EPF-3 | B-3 (100) | - | - | - | PGMEA (300) |
| EPF-4 | B-4 (100) | - | - | - | PGMEA (300) |
| EPF-5 | B-5 (100) | - | - | - | PGMEA (300) |
| EPF-6 | B-6 (100) | - | - | - | PGMEA (300) |
| EPF-7 | B-7 (100) | - | - | - | PGMEA (300) |
| EPF-8 | B-8 (100) | - | - | - | PGMEA (300) |
| EPF-9 | B-9 (100) | - | - | - | PGMEA (300) |
| EPF-10 | B-3 (100) | C1 (50) | - | - | PGMEA (300) |
| EPF-11 | B-6 (100) | C2 (50) | F-1 (2) | - | PGMEA (300) |
| EPF-12 | B-8 (100) | - | - | D1 (50) | PGMEA (250) |
| Comparative Example EPF-1 | R-1 (100) | - | - | - | PGMEA (300) |
| Comparative Example EPF-2 | R-2 (100) | - | - | - | PGMEA (300) |
| Comparative Example EPF-3 | R-3 (100) | - | - | - | PGMEA (300) |
| Comparative Example EPF-4 | R-4 (100) | C2 (10) | F-1 (2) | - | PGMEA (300) |
| Comparative Example EPF-5 | R-5 (100) | C2 (10) | F-1 (2) | - | PGMEA (300) |

### Examples 1-1 to 12, Comparative Examples 1-1 to 5: Evaluation of Thickness and Defects Of Wafer Edge Protection Films

Each of the above compositions for forming a wafer edge protection film (EPF-1 to 12 and Comparative Examples EPF-1 to 5) was supplied by spin coating to a peripheral edge (wafer edge) of a silicon wafer to form a protection film on the wafer edge. Then, the resulting protection film formed on the wafer edge was cured by baking for 60 seconds at the temperature shown in Table 4.

The thickness of the protection film formed on the wafer edge was evaluated by observation of cross section using an electron microscope (S-4700) manufactured by Hitachi, Ltd. The surface portion of the wafer edge (1.5 mm from the periphery Wb toward the center of the wafer) and the wafer apex were observed as the evaluation points, as shown in FIG. 8.

Also, the number of defects in the above protection film formed on the wafer edge was evaluated using VisEdge manufactured by KLA-Tencor. The case with less than 30 defects on the wafer edge protection film was evaluated as "A" (significantly desirable), the case with 30 to less than 100 defects was evaluated as "B" (desirable), and the case with 100 or more defects was evaluated as "C" (poor).

**Table 4**

| Examples | Composition for Forming Edge Protection Film | Baking Temperature (°C) | Film Thickness | | Number of Defects ( number/wf) |
|---|---|---|---|---|---|
| | | | Surface (nm) | Apex (nm) | |
| Example 1-1 | EPF-1 | 350 | 341 | 1763 | B |
| Example 1-2 | EPF-2 | 350 | 353 | 1549 | B |
| Example 1-3 | EPF-3 | 350 | 360 | 1610 | A |
| Example 1-4 | EPF-4 | 350 | 309 | 1738 | A |
| Example 1-5 | EPF-5 | 350 | 396 | 1685 | A |
| Example 1-6 | EPF-6 | 350 | 443 | 2014 | A |
| Example 1-7 | EPF-7 | 350 | 391 | 1846 | B |
| Example 1-8 | EPF-8 | 350 | 415 | 2122 | A |
| Example 1-9 | EPF-9 | 350 | 363 | 1633 | B |
| Example 1-10 | EPF-10 | 350 | 376 | 1535 | A |
| Example 1-11 | EPF-11 | 350 | 403 | 2232 | A |
| Example 1-12 | EPF-12 | 350 | 396 | 2077 | A |
| Comparative Example 1-1 | Comparative Examples EPF-1 | 350 | 355 | 1813 | C |
| Comparative Example 1-2 | Comparative Examples EPF-2 | 350 | 311 | 1465 | C |
| Comparative Example 1-3 | Comparative Examples EPF-3 | 350 | 371 | 1749 | C |
| Comparative Example 1-4 | Comparative Examples EPF-4 | 250 | 346 | 1496 | C |
| Comparative Example 1-5 | Comparative Examples EPF-5 | 250 | 351 | 1388 | C |

As shown in Table 4, the wafer edge protection film forming method using the compositions for forming a wafer edge protection film (EPF-1 to EPF-12) of the present invention enables desirable coverage from the wafer edge surface to the apex, and also enables formation of a protection film with an excellent defect suppression property. It is assumed that the organic group represented by the general formula (1) having an excellent thermal flowability contained therein made it possible to correct the shape change on the surface of the protection film, which is generated when the wafer edge protection film is applied by spin coating, by the thermal flow of the resin. On the other hand, as shown in Comparative Examples 1-1 to 1-5, in the wafer edge protection film forming methods using the comparative examples EPF-1 to 5 not containing the organic group represented by the general formula (1), the defects were significantly observed on the wafer edge protection films.

Furthermore, the compositions for forming a wafer edge protection film (EPF-3, 4, 6, 8, 10 to 12) containing a resin having a hydroxyl group in addition to the organic group represented by the general formula (1) exhibited a particularly excellent film forming property. It is assumed that containing a hydroxyl group in addition to the organic group represented by the general formula (1) improved wettability and adhesion with respect to the substrate, and that, therefore, a superior film forming property was exhibited in the compositions for forming a wafer edge protection film (EPF-3, 4, 6, 8, 10 to 12) containing both the organic group represented by the general formula (1) and the hydroxyl group, in contrast to the resin containing only the organic group represented by the general formula (1).

### Examples 2-1 to 12, Comparative Examples 2-1 to 5: Evaluation of Etching Resistance

Each of the compositions for forming a wafer edge protection film (EPF-1 to 12 and Comparative Examples EPF-1 to 5) prepared above was applied onto the surface of a silicon substrate, followed by baking in the atmosphere at the temperature shown in FIG. 5 for 60 seconds to form a 1200 nm coating film, and the film thickness A was measured. Next, etching with CF₄ gas and O₂ gas was performed for 1 minute under the following conditions using an etching apparatus Telius manufactured by Tokyo Electron Ltd., and the film thickness B was measured. The film thickness etched per minute (film thickness B - film thickness A) was calculated as etching resistance. For CF₄ gas etching, the case where the thickness difference between B and A was less than 75 nm was evaluated as "A" (significantly desirable), the case where the thickness difference was 75 nm or more and less than 80 nm was evaluated as "B" (desirable), and the case where the thickness difference was 80 nm or more was evaluated as "C" (poor). For O₂ gas etching, the case where the thickness difference between B and A was less than 110 nm was evaluated as "A" (significantly desirable), the case where the thickness difference was 110 nm or more and less than 120 nm was evaluated as "B" (desirable), and the case where the thickness difference was 120 nm or more was evaluated as "C" (poor). Table 5 shows the results.

### Conditions of Dry Etching with CF₄ Gas

Chamber pressure: 100 mT
RF-power (upper portion): 500W
RF-power (lower portion): 400W
CF₄ gas flow rate: 300 sccm
Time: 60 sec

### Conditions of Dry Etching with O₂ Gas

Chamber pressure: 15 mT
RF-power (upper portion): 300W
RF-power (lower portion): 50W
O₂ gas flow rate: 30 sccm
N₂ gas flow rate: 270 sccm
Time: 60 sec

**Table 5**

| Examples | Composition for Forming Edge Protection Film | Baking Temperature (°C) | Etching Resistance | |
|---|---|---|---|---|
| | | | CF₄ | O₂ |
| Example 2-1 | EPF-1 | 350 | A | A |
| Example 2-2 | EPF-2 | 350 | A | A |
| Example 2-3 | EPF-3 | 350 | A | A |
| Example 2-4 | EPF-4 | 350 | A | A |
| Example 2-5 | EPF-5 | 350 | A | A |
| Example 2-6 | EPF-6 | 350 | A | A |
| Example 2-7 | EPF-7 | 350 | B | B |
| Example 2-a | EPF-8 | 350 | B | B |
| Example 2-9 | EPF-9 | 350 | B | B |
| Example 2-10 | EPF-10 | 350 | A | A |
| Example 2-11 | EPF-11 | 350 | A | A |
| Example 2-12 | EPF-12 | 350 | B | B |
| Comparative Example 2-1 | Comparative Example EPF-1 | 350 | A | A |
| Comparative Example 2-2 | Comparative Example EPF-2 | 350 | A | A |
| Comparative Example 2-3 | Comparative Example EPF-3 | 350 | C | C |
| Comparative Example 2-4 | Comparative Example EPF-4 | 250 | C | C |
| Comparative Example 2-5 | Comparative Example EPF-5 | 250 | C | C |

As shown in Table 5, the compositions for forming a wafer edge protection film (EPF-1 to EPF-12) of the present invention have excellent dry etching resistance with respect to CF₄ gas and O₂ gas. The compositions are capable of forming a dense cured film and exhibiting excellent dry etching resistance presumably because of the aromatic ring with a high carbon content and the organic group represented by the general formula (1) contained therein, as well as the excellent reactivity of the organic group represented by the general formula (1). In particular, it was revealed that the compositions for forming a wafer edge protection film (EPF-1 to 6, EPF-10 to 11) obtained by using a resin containing a cardo structure and the organic group represented by the general formula (1) exhibit significantly excellent resistance. Since Comparative Examples EPF-1 and EPF-2 also contain a cardo structure, they exhibited excellent dry etching resistance.

On the other hand, the compositions for forming a wafer edge protection film without a cardo structure and the organic group represented by the general formula (1) (Comparative Examples EPF-3 to 5) exhibited insufficient dry etching resistance. In comparison between EPF-7 and Comparative Example EPF-3 having the same scaffold structure, EPF-7 having the organic group represented by the general formula (1) is superior in dry etching resistance; therefore, it is assumed that the organic group represented by the general formula (1) contributes to the formation of a dense cured film.

As described above, it was revealed that the compositions for forming a wafer edge protection film (EPF-1 to EPF-12) used for the wafer edge protection film forming method of the present invention have excellent dry etching resistance with respect to CF₄ gas and O₂ gas. Therefore, the wafer edge protection film forming method using these compositions is expected to form a protection film capable of protecting the wafer edge from etchant until etching on the substrate to be processed is completed, even during a dry etching process for forming fine patterns with high aspect ratios typified by 3D-NAND memory, which is becoming increasingly highly stacked.

### Example 3-1, Comparative Example 3-1: Amount of Surface Metallic Impurities on Wafer Peripheral Edge

The amount of metal impurities on the wafer peripheral edge generated from the metal-containing resist upper layer film was evaluated. The metal-containing compounds (M-1) to (M-3) used for this evaluation were synthesized as follows.

### Synthesis of Metal-Containing Compound (M-1)

340 g of titanium tetrabutoxide was dissolved in 500 g of 1-butanol, and a mixed solution of 27 g of deionized water and 500 g of 1-butanol was added thereto dropwise over 2 hours at room temperature while stirring. 1,200 g of propylene glycol monomethylether acetate (PGMEA) was added to the resulting solution, and the mixture was heated at 50°C under reduced pressure until distillation of 1-butanol stopped, thereby obtaining 1,000 g of titanium-containing compound dissolved in PGMEA. The molecular weight on polystyrene basis of this compound was measured, with the result that Mw = 1,050.

### Synthesis of Metal-Containing Compound (M-2)

480 g of 1-butanol solution of 80 % by mass of zirconium tetraisopropoxide was dissolved in 400 g of 1-butanol, and a mixed solution of 27 g of deionized water and 500 g of 1-butanol was added thereto dropwise over 2 hours at room temperature while stirring. 90 g of 1,3-butanediol was added to the resulting solution, followed by stirring at room temperature for 30 minutes. This solution was concentrated at 30°C under reduced pressure, and further heated to 60°C. The heating was continued under reduced pressure until no distillates were produced. At a point where distillates were no longer observed, 1,200 g of PGMEA was added, and the mixture was heated at 40°C under reduced pressure until distillation of 1-butanol stopped, thereby obtaining 1,000 g of a zirconium-containing compound dissolved in PGMEA. The molecular weight on polystyrene basis of this compound was measured, with the result that Mw = 1,400.

### Synthesis of Metal-Containing Compound (M-3)

480 g of 1-butanol solution of 80 % by mass of hafnium tetraisopropoxide was dissolved in 400 g of 1-butanol, and a mixed solution of 27 g of deionized water and 500 g of 1-butanol was added thereto dropwise over 2 hours at room temperature while stirring. 90 g of 1,3-butanediol was added to the resulting solution, followed by stirring at room temperature for 30 minutes. This solution was concentrated at 30°C under reduced pressure, and further heated to 60°C. The heating was continued under reduced pressure until no distillates were produced. At a point where distillates were no longer observed, 1,200 g of PGMEA was added, and the mixture was heated at 40°C under reduced pressure until distillation of 1-butanol stopped, thereby obtaining 1,000 g of a hafnium-containing compound dissolved in PGMEA. The molecular weight on polystyrene basis of this compound was measured, with the result that Mw = 1,500.

### Preparation of Metal-Containing Resist

Each of the metal-containing compounds (M-1) to (M-3) obtained in the above Synthesis Examples was dissolved in a solvent in which 100 ppm of FC-4430 (a fluorine-based surfactant manufactured by 3M Ltd.) as a surfactant was dissolved according to the formulations shown in Table 6. Each solution was filtered through a 0.2 um filter to prepare metal-containing resists MR-1 to 3.

The formulations in the following Table 6 are as follows.
Acid generator: PAG-1, 2 (see the following structural formula)
Basic compound: Base-1 (see the following structural formula)

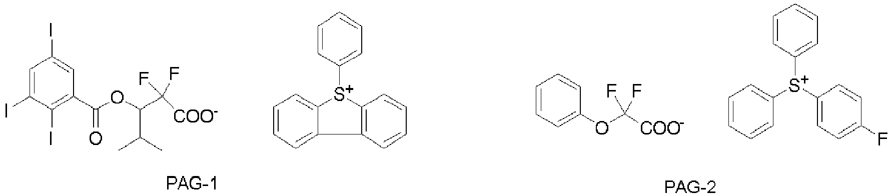

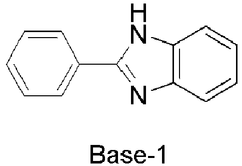

**Table 6**

| Metal-Containing Resist | Metal-Containing Compound (part by mass) | Acid Generator (part by mass) | Basic Compound (part by mass) | Solvent (part by mass) |
|---|---|---|---|---|
| MR-1 | M-1 (100) | PAG-1 (10) | Base-1 (2) | PGMEA (6000) |
| MR-2 | M-2 (100) | PAG-2 (5) | Base-1 (2) | PGMEA (6000) |
| MR-3 | M-3 (100) | PAG-2 (5) | Base-1 (2) | PGMEA (6000) |

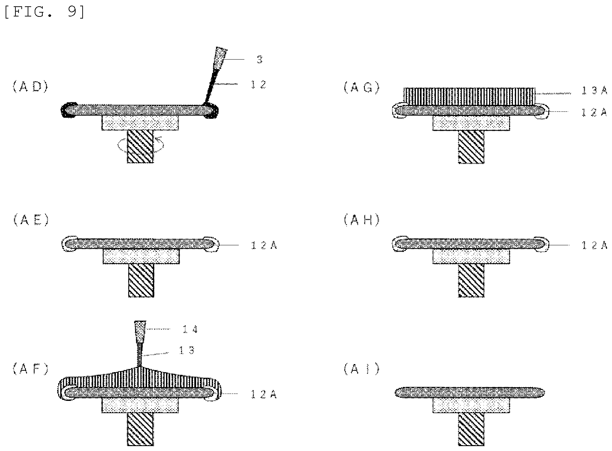

As shown in FIG. 9, the composition for forming a protection film (EPF-1) 12 prepared above was applied from the supply nozzle 3 to the peripheral edge on the surface side and the peripheral edge on the backside of a silicon substrate (FIG. 9(AD)), followed by baking at 350°C for 60 seconds in the atmosphere to form protection films 12A (FIG. 9(AE)). Then, the composition for forming a metal-containing resist upper layer film (MR-1 to 3 described above) 13 was applied from a resist supply nozzle 14 to the surface portion of the silicon substrate (FIG. 9(AF)), followed by pre-baking on a hotplate for 60 seconds under 170°C to form a metal-containing resist upper layer film 13A of 35 nm (FIG. 9(AG)). Subsequently, the above metal-containing resist upper layer film 13A was removed using a developer (butyl acetate) (FIG. 9(AH)), and then the protection films 12A formed on the peripheral edge on the surface side and the peripheral edge on the backside of the silicon substrate were removed by dry etching using O₂ gas (FIG. 9(AI)). The peripheral edge on the surface side and the peripheral edge on the backside of the silicon substrate were treated with a mixed liquid of hydrofluoric acid and hydrogen peroxide water, and the solution was recovered and evaluated using Expert VPD-ICP-MS manufactured by IAS Inc.

As a Comparative Example, a metal-containing resist was applied to the surface portion of a silicon substrate without using the composition for forming a wafer edge protection film. The case where the amount of metal atom impurities in the above metal-containing resist is 1.0 × 10E^{+ 10} (atoms/cm²) or less was evaluated as "A" (desirable), and the case where the amount of metal atom impurities is more than 1.0 × 10E⁺¹⁰(atoms/cm²) was evaluated as "B" (poor). Table 7 shows the results.

**Table 7**

| Examples | composition for Forming Edge Protection Film | Metal-Containing Resist | | |
|---|---|---|---|---|
| | | MR-1 (Ti) | MR-2 (Zr) | MR-3 (Hf) |
| Example 3-1 | EPF-1 | A | A | A |
| Comparative Example 3-1 | - | B | B | B |

As shown in Table 7, by forming the composition for forming a wafer edge protection film (EPF-1) of the present invention as a protection film on the peripheral edge on the surface side and the peripheral edge on the backside, the amount of metal adhering when the metal-containing resist is applied to the silicon substrate significantly decreased compared with the case in which the composition for forming a protection film was not used.

As explained above, the wafer edge protection film forming method using the composition for forming a wafer edge protection film of the present invention provides a wafer edge protection film superior in dry etching resistance compared with previously-known wafer edge protection films, as well as excellent film forming property even at a wafer edge portion, which is difficult to coat. Further, by forming a protection film also on the peripheral edge on the backside, it is possible to prevent such a risk that the chemical liquid supplied to the surface of the substrate may run into the peripheral portion on the backside during the formation of a coating film containing a metal, thus forming a coating film also on the peripheral portion on the backside for which formation of a coating film is not intended, resulting in metal contamination in these areas. Therefore, they can be suitably used for the formation of fine resist patterns in the lithography steps for various electronic devices, such as semiconductor devices, liquid crystal devices, and the like, which are expected to undergo further miniaturization in the future.

The present invention encompasses the following inventions.
[1]. A wafer edge protection film forming method for forming a protection film on a peripheral edge of a substrate, comprising the steps of:
   (i) coating a peripheral edge of the substrate with a composition for forming a protection film comprising an aromatic ring-containing resin (A) having an organic group represented by the following general formula (1), and a solvent; and
   (ii) curing the applied composition for forming a protection film by heat or optical irradiation to form the protection film on the peripheral edge of the substrate, 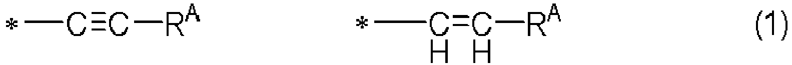
   wherein R^{A} is a hydrogen atom or a monovalent organic group having 1 to 10 carbon atoms, and * represents a bonding site.
[2]. The wafer edge protection film forming method according to [1] above, wherein the resin (A) further comprises a hydroxyl group, and the ratio of the number of the hydroxyl groups to the number of the organic groups represented by the general formula (1) satisfies a relationship a+b=1 and 0.1≤b≤0.9 wherein "a" represents the proportion of the hydroxyl group and "b" represents the proportion of the organic group represented by the general formula (1).
[3]. The wafer edge protection film forming method according to [1] or [2] above, wherein the resin (A) is an aromatic ring-containing resin having a hydroxyl group and an organic group represented by the following general formula (1A), and the ratio of the number of the hydroxyl groups to the number of the organic groups represented by the general formula (1A) satisfies a relationship c+d=1 and 0.1≤d≤0.9 wherein "c" represents the proportion of the hydroxyl group and "d" represents the proportion of the organic group represented by the general formula (1A). 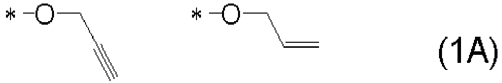 wherein * represents a bonding site.
[4]. The wafer edge protection film forming method according to [1], [2] or [3] above, wherein the resin (A) is a compound having a ratio Mw/Mn (i.e., dispersity) in a range of 1.00≤Mw/Mn≤1.25, the Mw/Mn being a ratio of the weight average molecular weight Mw to the number average molecular weight Mn on polystyrene basis according to gel permeation chromatography.
[5]. The wafer edge protection film forming method according to [1], [2], [3] or [4] above, wherein the resin (A) is a polymer having a weight average molecular weight on polystyrene basis according to gel permeation chromatography of 1,000 to 12,000.
[6]. The wafer edge protection film forming method according to [1], [2], [3], [4] or [5] above, wherein the resin (A) comprises at least one of the constituent units represented by the following general formulae (A-1), (A-2), (A-3), (A-4), and (A-5), 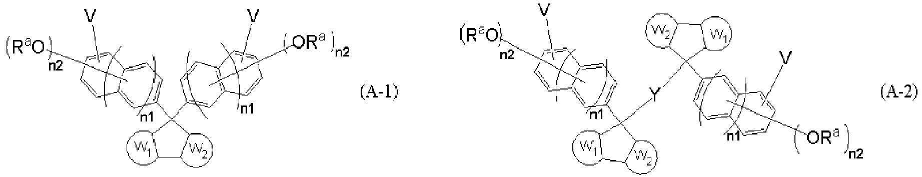 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} represents a hydrogen atom or an organic group represented by the following general formula (2), and satisfies a relationship e+f=1 and 0.1≤f≤0.9, wherein "e" represents the proportion of the hydrogen atom and "f" represents the proportion of the organic group represented by the general formula (2) among the structures constituting R^{a}; Y is a group represented by the following general formula (3); n₁ is 0 or 1; n₁ is 1 or 2; and V independently represents a hydrogen atom or a connection portion, 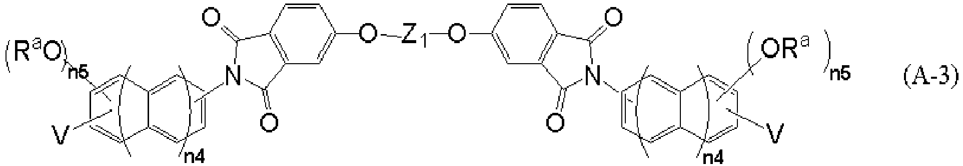 wherein Z₁ is a group represented by the following general formula (4), and R^{a} represents a hydrogen atom or an organic group represented by the following general formula (2) and satisfies a relationship e+f=1 and 0.1≤f≤0.9, wherein "e" represents the proportion of the hydrogen atom and "f" represents the proportion of the organic group represented by the general formula (2) among the structures constituting R^{a}; n₄ is 0 or 1, n₅ is 1 or 2, and V independently represents a hydrogen atom or a connection portion, 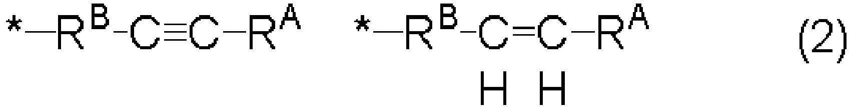 wherein * represents a site bonded with the oxygen atom, R^{B} represents a divalent organic group having 1 to 10 carbon atoms, and R^{A} represents a hydrogen atom or a monovalent organic group having 1 to 10 carbon atoms, 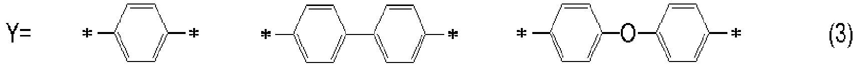 wherein * represents a bonding arm, 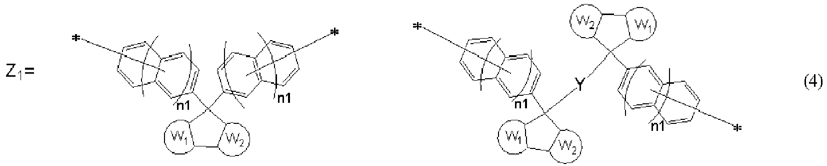 wherein W₁, W₂, Y, and n₁ are as defined above, 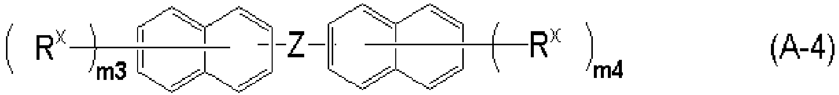 wherein m₃ and m₄ represent 1 or 2; Z represents either a single bond or the structure represented by the following general formula (5); and R^{X} is any one of the structures represented by the following general formula (6), 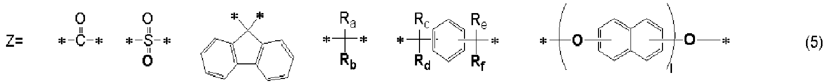 wherein * represents a bonding arm; 1 represents an integer of 0 to 3; R^{a} to R_{f} each independently represent a hydrogen atom or an optionally fluorine-substituted alkyl group having 1 to 10 carbon atoms, an optionally fluorine-substituted phenyl group, or an optionally fluorine-substituted phenylethyl group, and R^{a} and R_{b} may be bonded to each other to form a cyclic compound, 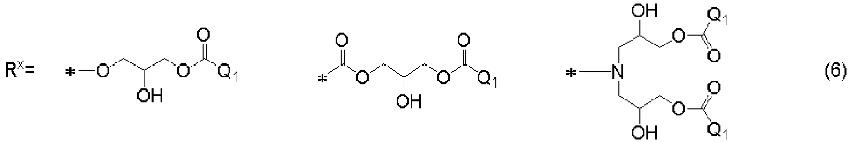 wherein * represents a site bonded with the aromatic ring; Q₁ is a linear saturated hydrocarbon group having 1 to 30 carbon atoms, or the structure represented by the following general formula (7), 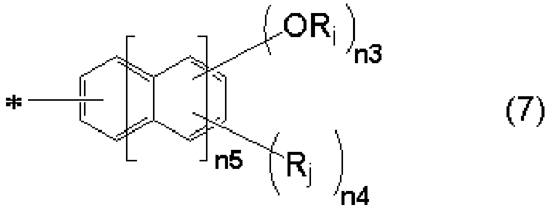 wherein * represents a site bonded with the carbonyl group; Rᵢ represents a hydrogen atom or the organic group represented by the general formula (2), and satisfies a relationship e+f=1 and 0.1≤f≤0.9, wherein "e" represents the proportion of the hydrogen atom and "f" represents the proportion of the organic group represented by the general formula (2) among the structures constituting Rᵢ; Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; n₃ and n₄ are each an integer of 0 to 7 that represents the number of substituents on the aromatic ring, provided that n₃ + n₄ is 0 or more and 7 or less; and n₅ represents 0 to 2, 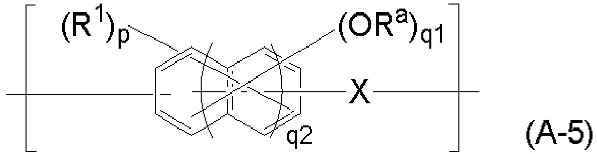 wherein R¹ represents a saturated monovalent organic group having 1 to 30 carbon atoms or an unsaturated monovalent organic group having 2 to 30 carbon atoms; X is a divalent organic group having 1 to 30 carbon atoms; and R^{a} represents a hydrogen atom or the organic group represented by the general formula (2), and satisfies a relationship e+f=1 and 0.1≤f≤0.9, wherein "e" represents the proportion of the hydrogen atom and "f" represents the proportion of the organic group represented by the general formula (2) among the structures constituting R^{a}; p is an integer of 0 to 5; q₁ is an integer of 1 to 6; p+q₁ is an integer of 1 or more and 6 or less; and q₂ is 0 or 1.
[7]. The wafer edge protection film forming method according to [1], [2], [3], [4], [5] or [6] above, wherein the content of the resin (A) in the composition for forming a protection film is 10% by mass or more.
[8]. The wafer edge protection film forming method according to [1], [2], [3], [4], [5], [6] or [7] above, wherein the composition for forming a protection film further comprises one or more of a crosslinking agent, a high boiling point solvent, a surfactant, an acid generator, and a plasticizer.
[9]. The wafer edge protection film forming method according to [1], [2], [3], [4], [5], [6], [7] or [8] above, wherein, in the step (i), in addition to the peripheral edge on the surface side of the substrate, the composition for forming a protection film is applied also to the peripheral edge on the backside of the substrate, thereby forming the protection film also on the peripheral edge on the backside of the substrate in the step (ii).
[10]. The wafer edge protection film forming method according to [1], [2], [3], [4], [5], [6], [7], [8] or [9] above, wherein the coating in the step (i) is performed using a spin coating method, and the protection film is not formed on areas other than the peripheral edge on the surface side of the substrate and the peripheral edge on the backside of the substrate.
[11]. The wafer edge protection film forming method according to [1], [2], [3], [4], [5], [6], [7], [8], [9] or [10] above, wherein, in the step (ii), the applied composition for forming a protection film is cured by heat treatment at a temperature of 100°C or more and 800°C or less for 10 seconds to 7,200 seconds.
[12]. A patterning process for forming a protection film on a peripheral edge of a substrate to be processed on which a film with a pattern is formed, and forming a pattern on the substrate to be processed, the patterning process comprising the steps of:
   (I-1) applying a composition for forming a protection film comprising an aromatic ring-containing resin (A) having an organic group represented by the following general formula (1) and a solvent to a peripheral edge of a substrate to be processed on which a film with a pattern is formed;
   (I-2) curing the applied composition for forming a protection film by a heat treatment or optical irradiation to form a protection film on the peripheral edge of the substrate;
   (I-3) forming a pattern on the substrate to be processed by dry etching while using the film with a pattern as a mask; and
   (I-4) removing the protection film, 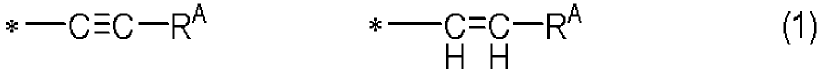 wherein R^{A} is a hydrogen atom or a monovalent organic group having 1 to 10 carbon atoms, and * represents a bonding site.
[13]. A patterning process for forming a protection film on a peripheral edge of a substrate to be processed, and forming a pattern on the substrate to be processed, the patterning process comprising the steps of:
   (II-1) applying a composition for forming a protection film comprising an aromatic ring-containing resin (A) having an organic group represented by the following general formula (1) and a solvent to a peripheral edge of a substrate to be processed;
   (II-2) curing the applied composition for forming a protection film by a heat treatment or optical irradiation to form a protection film on the peripheral edge of the substrate to be processed;
   (II-3) forming a resist upper layer film pattern on the substrate to be processed and forming a pattern on the substrate to be processed by dry etching while using the resist upper layer film pattern as a mask; and
   (II-4) removing the protection film, 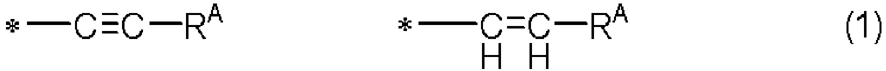
   wherein R^{A} is a hydrogen atom or a monovalent organic group having 1 to 10 carbon atoms, and * represents a bonding site.
[14]. The patterning process according to [12] or [13] above, wherein, in the step (I-1) or (II-1), in addition to the peripheral edge on the surface side of the substrate, the composition for forming a protection film is applied also to a peripheral edge on the backside of the substrate, thereby forming the protection film also on the peripheral edge on the backside of the substrate in the step (I-2) or (II-2).
[15]. A composition for forming a protection film to be used for forming a protection film on a peripheral edge of a substrate, comprising:
   an aromatic ring-containing resin (A) having an organic group represented by the following general formula (1): and
   a solvent, 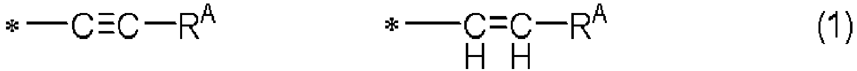
   wherein R^{A} represents a hydrogen atom or a monovalent organic group having 1 to 10 carbon atoms, and * represents a bonding site.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A wafer edge protection film forming method for forming a protection film on a peripheral edge of a substrate, comprising the steps of:
(i) coating a peripheral edge of the substrate with a composition for forming a protection film comprising an aromatic ring-containing resin (A) having an organic group represented by the following general formula (1), and a solvent; and
(ii) curing the applied composition for forming a protection film by heat or optical irradiation to form the protection film on the peripheral edge of the substrate, 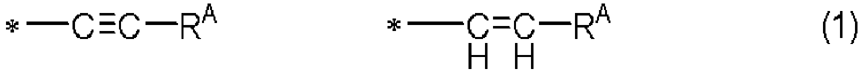 wherein R^{A} is a hydrogen atom or a monovalent organic group having 1 to 10 carbon atoms, and * represents a bonding site.

2. The wafer edge protection film forming method according to claim 1, wherein the resin (A) further comprises a hydroxyl group, and the ratio of the number of the hydroxyl groups to the number of the organic groups represented by the general formula (1) satisfies a relationship a+b=1 and 0.1≤b≤0.9 wherein "a" represents the proportion of the hydroxyl group and "b" represents the proportion of the organic group represented by the general formula (1).

3. The wafer edge protection film forming method according to claim 1, wherein the resin (A) is an aromatic ring-containing resin having a hydroxyl group and an organic group represented by the following general formula (1A), and the ratio of the number of the hydroxyl groups to the number of the organic groups represented by the general formula (1A) satisfies a relationship c+d=1 and 0.1≤d≤0.9 wherein "c" represents the proportion of the hydroxyl group and "d" represents the proportion of the organic group represented by the general formula (1A). 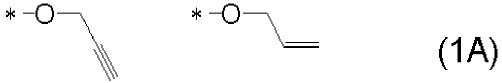 wherein * represents a bonding site.

4. The wafer edge protection film forming method according to claim 1, wherein the resin (A) is a compound having a ratio Mw/Mn (i.e., dispersity) in a range of 1.00≤Mw/Mn≤1.25, the Mw/Mn being a ratio of the weight average molecular weight Mw to the number average molecular weight Mn on polystyrene basis according to gel permeation chromatography.

5. The wafer edge protection film forming method according to claim 1, wherein the resin (A) is a polymer having a weight average molecular weight on polystyrene basis according to gel permeation chromatography of 1,000 to 12,000.

6. The wafer edge protection film forming method according to claim 1, wherein the resin (A) comprises at least one of the constituent units represented by the following general formulae (A-1), (A-2), (A-3), (A-4), and (A-5), 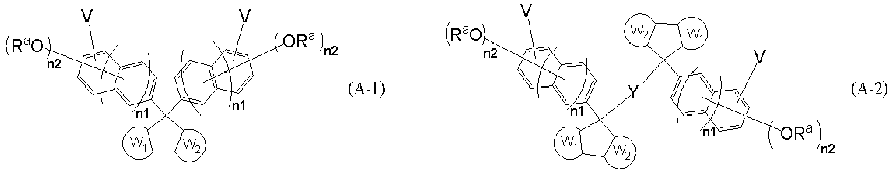 wherein W₁ and W₂ each independently represent a benzene ring or a naphthalene ring, and hydrogen atoms in the benzene ring and the naphthalene ring are optionally substituted with a hydrocarbon group having 1 to 6 carbon atoms; R^{a} represents a hydrogen atom or an organic group represented by the following general formula (2), and satisfies a relationship e+f=1 and 0.1≤f≤0.9, wherein "e" represents the proportion of the hydrogen atom and "f" represents the proportion of the organic group represented by the general formula (2) among the structures constituting R^{a}; Y is a group represented by the following general formula (3); n₁ is 0 or 1; n₁ is 1 or 2; and V independently represents a hydrogen atom or a connection portion, 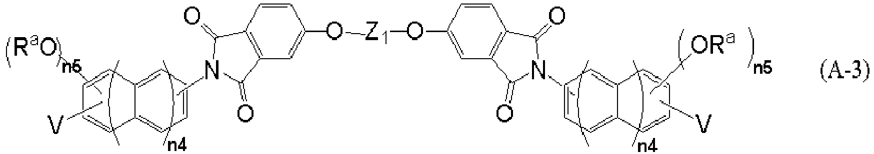 wherein Z₁ is a group represented by the following general formula (4), and R^{a} represents a hydrogen atom or an organic group represented by the following general formula (2) and satisfies a relationship e+f=1 and 0.1≤f≤0.9, wherein "e" represents the proportion of the hydrogen atom and "f" represents the proportion of the organic group represented by the general formula (2) among the structures constituting R^{a}; n₄ is 0 or 1, n₅ is 1 or 2, and V independently represents a hydrogen atom or a connection portion, 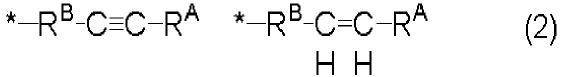 wherein * represents a site bonded with the oxygen atom, R^{B} represents a divalent organic group having 1 to 10 carbon atoms, and R^{A} represents a hydrogen atom or a monovalent organic group having 1 to 10 carbon atoms, 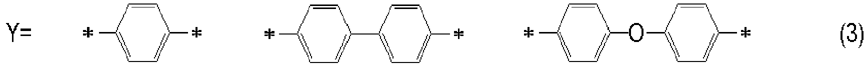 wherein * represents a bonding arm, 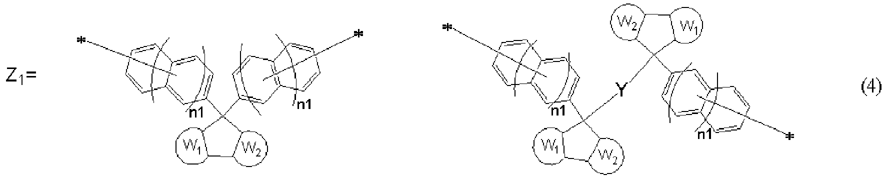 wherein W₁, W₂, Y, and n₁ are as defined above, 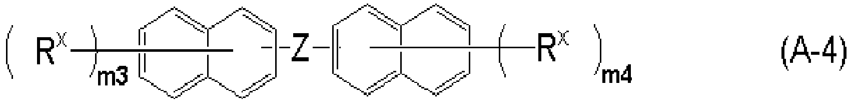 wherein m₃ and m₄ represent 1 or 2; Z represents either a single bond or the structure represented by the following general formula (5); and R^{X} is any one of the structures represented by the following general formula (6), 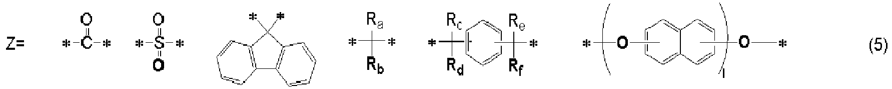 wherein * represents a bonding arm; l represents an integer of 0 to 3; Rₐ to R_{f} each independently represent a hydrogen atom or an optionally fluorine-substituted alkyl group having 1 to 10 carbon atoms, an optionally fluorine-substituted phenyl group, or an optionally fluorine-substituted phenylethyl group, and Rₐ and R_{b} may be bonded to each other to form a cyclic compound, 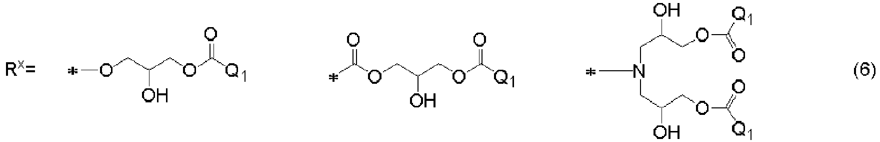 wherein * represents a site bonded with the aromatic ring; Q₁ is a linear saturated hydrocarbon group having 1 to 30 carbon atoms, or the structure represented by the following general formula (7), 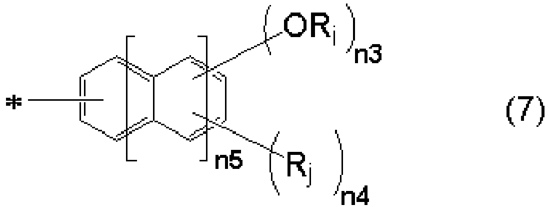 wherein * represents a site bonded with the carbonyl group; Rᵢ represents a hydrogen atom or the organic group represented by the general formula (2), and satisfies a relationship e+f=1 and 0.1≤f≤0.9, wherein "e" represents the proportion of the hydrogen atom and "f" represents the proportion of the organic group represented by the general formula (2) among the structures constituting Rᵢ; Rⱼ represents a linear or branched hydrocarbon group having 1 to 10 carbon atoms, a halogen atom, a nitro group, an amino group, a nitrile group, an alkoxycarbonyl group having 1 to 10 carbon atoms, or an alkanoyloxy group having 1 to 10 carbon atoms; n₃ and n₄ are each an integer of 0 to 7 that represents the number of substituents on the aromatic ring, provided that n₃ + n₄ is 0 or more and 7 or less; and n₅ represents 0 to 2, 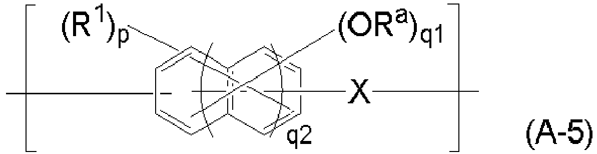 wherein R¹ represents a saturated monovalent organic group having 1 to 30 carbon atoms or an unsaturated monovalent organic group having 2 to 30 carbon atoms; X is a divalent organic group having 1 to 30 carbon atoms; and R^{a} represents a hydrogen atom or the organic group represented by the general formula (2), and satisfies a relationship e+f=1 and 0.1≤f≤0.9, wherein "e" represents the proportion of the hydrogen atom and "f" represents the proportion of the organic group represented by the general formula (2) among the structures constituting R^{a}; p is an integer of 0 to 5; q₁ is an integer of 1 to 6; p+q₁ is an integer of 1 or more and 6 or less; and q₂ is 0 or 1.

7. The wafer edge protection film forming method according to claim 1, wherein the content of the resin (A) in the composition for forming a protection film is 10% by mass or more.

8. The wafer edge protection film forming method according to claim 1, wherein the composition for forming a protection film further comprises one or more of a crosslinking agent, a high boiling point solvent, a surfactant, an acid generator, and a plasticizer.

9. The wafer edge protection film forming method according to any one of claims 1 to 8, wherein, in the step (i), in addition to the peripheral edge on the surface side of the substrate, the composition for forming a protection film is applied also to the peripheral edge on the backside of the substrate, thereby forming the protection film also on the peripheral edge on the backside of the substrate in the step (ii).

10. The wafer edge protection film forming method according to any one of claims 1 to 8, wherein the coating in the step (i) is performed using a spin coating method, and the protection film is not formed on areas other than the peripheral edge on the surface side of the substrate and the peripheral edge on the backside of the substrate.

11. The wafer edge protection film forming method according to any one of claims 1 to 8, wherein, in the step (ii), the applied composition for forming a protection film is cured by heat treatment at a temperature of 100°C or more and 800°C or less for 10 seconds to 7,200 seconds.

12. A patterning process for forming a protection film on a peripheral edge of a substrate to be processed on which a film with a pattern is formed, and forming a pattern on the substrate to be processed, the patterning process comprising the steps of:
(I-1) applying a composition for forming a protection film comprising an aromatic ring-containing resin (A) having an organic group represented by the following general formula (1) and a solvent to a peripheral edge of a substrate to be processed on which a film with a pattern is formed;
(I-2) curing the applied composition for forming a protection film by a heat treatment or optical irradiation to form a protection film on the peripheral edge of the substrate;
(I-3) forming a pattern on the substrate to be processed by dry etching while using the film with a pattern as a mask; and
(I-4) removing the protection film, 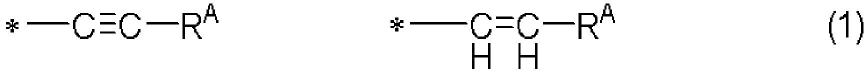 wherein R^{A} is a hydrogen atom or a monovalent organic group having 1 to 10 carbon atoms, and * represents a bonding site.

13. A patterning process for forming a protection film on a peripheral edge of a substrate to be processed, and forming a pattern on the substrate to be processed, the patterning process comprising the steps of:
(II-1) applying a composition for forming a protection film comprising an aromatic ring-containing resin (A) having an organic group represented by the following general formula (1) and a solvent to a peripheral edge of a substrate to be processed;
(II-2) curing the applied composition for forming a protection film by a heat treatment or optical irradiation to form a protection film on the peripheral edge of the substrate to be processed;
(II-3) forming a resist upper layer film pattern on the substrate to be processed and forming a pattern on the substrate to be processed by dry etching while using the resist upper layer film pattern as a mask; and
(II-4) removing the protection film, 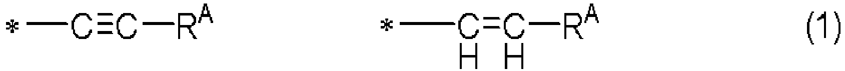 wherein R^{A} is a hydrogen atom or a monovalent organic group having 1 to 10 carbon atoms, and * represents a bonding site.

14. The patterning process according to claim 12 or 13, wherein, in the step (I-1) or (II-1), in addition to the peripheral edge on the surface side of the substrate, the composition for forming a protection film is applied also to a peripheral edge on the backside of the substrate, thereby forming the protection film also on the peripheral edge on the backside of the substrate in the step (I-2) or (II-2).

15. A composition for forming a protection film to be used for forming a protection film on a peripheral edge of a substrate, comprising:
an aromatic ring-containing resin (A) having an organic group represented by the following general formula (1): and
a solvent, 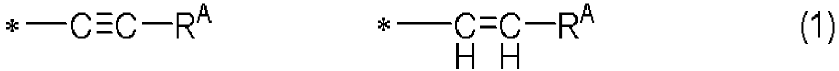 wherein R^{A} represents a hydrogen atom or a monovalent organic group having 1 to 10 carbon atoms, and * represents a bonding site.
